# EUROPEAN PATENT APPLICATION

(11) **EP 4 498 419 A2**
(43) Date of publication of application: **29.01.2025**
(21) Application number: 24175779.8
(22) Date of filing: 14.05.2024
(51) Int. Cl.: H01L 21/822, H01L 21/8238, H01L 27/06, H01L 27/092, H01L 29/06, H01L 29/66, H01L 29/775, H01L 29/786

(54) **SEMICONDUCTOR DEVICE**

(30) Priority: 25.07.2023 KR 20230096618
(71) Applicant: Samsung Electronics Co., Ltd., Suwon-si, Gyeonggi-do 16677 (KR)
(72) Inventor: KIM, Dahye, 16677 Suwon-si (KR); YUN, Jinchan, 16677 Suwon-si (KR); HUH, Daihong, 16677 Suwon-si (KR); PARK, Jaehyun, 16677 Suwon-si (KR)
(74) Representative: Marks & Clerk LLP

(57) **Abstract**

A semiconductor device is described. The devices include lower and upper channel layers over an active region on a substrate. The device further includes a middle insulating structure disposed between the lower and the upper channels. The device includes gate structures surrounding the channel layers, lower and upper source/drain regions disposed on the active region on at least one side of the gate structures. Between the lower and upper source/drain regions is a barrier structure. The lower and upper source/drain regions may each fill a lower recess region or an upper recess region, respectively. These recess regions are defined by the respective channel layers, the gate structures, and by the barrier structure. The side surface slopes within the upper and the lower recess regions may vary and the side surface slopes of each of the recess regions may be different from each other.

## Description

### BACKGROUND

There is a high demand for techniques for reducing the size of semiconductor devices.

### SUMMARY

An example embodiment of the present disclosure is provides a semiconductor device having improved electrical properties and reliability.

In general, in some aspects, the subject matter of the present application is directed to a semiconductor device that includes: an active region extending on a substrate in a first direction; a device isolation layer disposed on the substrate and defining the active region; lower channel layers spaced apart from each other in a vertical direction perpendicular to an upper surface of the substrate; upper channel layers disposed on the lower channel layers and spaced apart from each other in the vertical direction; an intermediate insulating structure disposed between an uppermost lower channel layer among the lower channel layers and a lowermost upper channel layer among the upper channel layers; gate structures intersecting the active region, surrounding each of the lower channel layers and each of the upper channel layers and extending in a second direction; a lower source/drain region disposed on the active region on at least one side of the gate structures and connected to the lower channel layers; an upper source/drain region connected to each of the upper channel layers on at least one side of the gate structures and spaced apart from the lower source/drain region in the vertical direction; and a barrier structure disposed between the lower source/drain region and the upper source/drain region, wherein the lower source/drain region fills a lower recess region defined by a side surface of the lower channel layers, a side surface of the gate structures, and an upper surface of the active region, wherein the upper source/drain region fills an upper recess region defined by a side surface of the upper channel layers, a side surface of the gate structures, and a lower surface and a side surface of the barrier structure, and wherein a slope of a side surface of the lower recess region and a slope of a side surface of the upper recess region have slopes of opposite signs.

In general, in some aspects, the subject matter of the present application is directed to a semiconductor device that includes: an active region extending on a substrate in a first direction; a device isolation layer disposed on the substrate and defining the active region; lower channel layers spaced apart from each other in a vertical direction perpendicular to an upper surface of the substrate; upper channel layers disposed on the lower channel layers" and spaced apart from each other in the vertical direction; an intermediate insulating structure disposed between the uppermost lower channel layer among the lower channel layers and the lowermost upper channel layer among the upper channel layers; a lower gate structure intersecting the active region, surrounding each of the lower channel layers, extending in the second direction, and disposed below a lower surface of the intermediate insulating structure; an upper gate structure surrounding each of the upper channel layers, extending in the second direction, and disposed on an upper surface of the intermediate insulating structure; a lower source/drain region disposed on the active region on at least one side of the lower gate structure and connected to each of the lower channel layers; an upper source/drain region connected to each of the upper channel layers on at least one side of the upper gate structure and spaced apart from the lower source/drain region in the vertical direction; and a barrier structure disposed between the lower source/drain region and the upper source/drain region, wherein a width of an upper portion of the lower source/drain region in the first direction is greater than a width of a lower portion of the barrier structure in the first direction, wherein a width of the lower gate structure in the first direction decreases toward an upper surface of the substrate, and wherein a width of the upper gate structure in the first direction increases toward an upper surface of the substrate.

In general, in n some aspects, the subject matter of the present application is directed to a semiconductor device includes an active region extending on a substrate in a first direction; a plurality of channel layers spaced apart from each other in a vertical direction perpendicular to an upper surface of the substrate; gate structures intersecting the active region, surrounding each of the plurality of channel layers and extending in a second direction; a lower source/drain region disposed on the active region on at least one side of the gate structures and connected to a portion of the plurality of channel layers; an upper source/drain region connected to the other portion of the plurality of channel layers on at least one side of the gate structures and spaced apart from the lower source/drain region in the vertical direction; and a barrier structure disposed between the lower source/drain region and the upper source/drain region, wherein the lower source/drain region includes a first lower inclined surface having a first slope and a second lower inclined surface having a second slope different from the first slope of the first lower inclined surface.

At least some of the above and other features of the invention are set out in the claims.

### BRIEF DESCRIPTION OF THE DRAWINGS

The above and other aspects, features, and advantages of the present disclosure will be more clearly understood from the following detailed description, taken in combination with the accompanying drawings, in which:
FIG. 1 is a plan diagram illustrating an example of a semiconductor device;
FIG. 2A illustrates cross-sectional diagrams of an example of a semiconductor device;
FIG. 2B is an enlarged cross-sectional diagram illustrating a portion of an example of a semiconductor device;
FIGS. 3 to 15 are enlarged cross-sectional diagrams illustrating a portion of an example of a semiconductor device;
FIG. 16A illustrates cross-sectional diagrams of an example of a semiconductor device;
FIG. 16B is an enlarged cross-sectional diagram illustrating a portion of an example of a semiconductor device;
FIG. 17 is an enlarged cross-sectional diagram illustrating a portion of an example of a semiconductor device;
FIG. 18 illustrates cross-sectional diagrams of a portion of an example of a semiconductor device;
FIGS. 19A to 19H are cross-sectional diagrams illustrating an example method of manufacturing a semiconductor device; and
FIGS. 20A to 20J are cross-sectional diagrams illustrating an example method of manufacturing a semiconductor device.

### DETAILED DESCRIPTION

Hereinafter, implementations of the present disclosure will be described as follows with reference to the accompanying drawings.

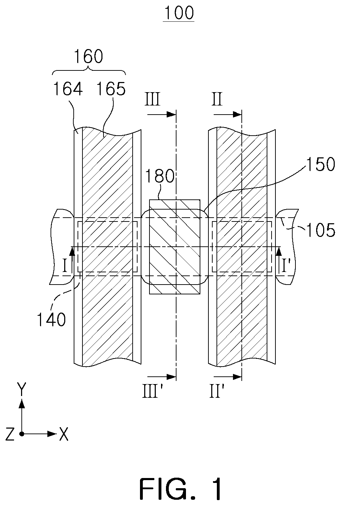

FIG. 1 is a plan diagram illustrating a semiconductor device.

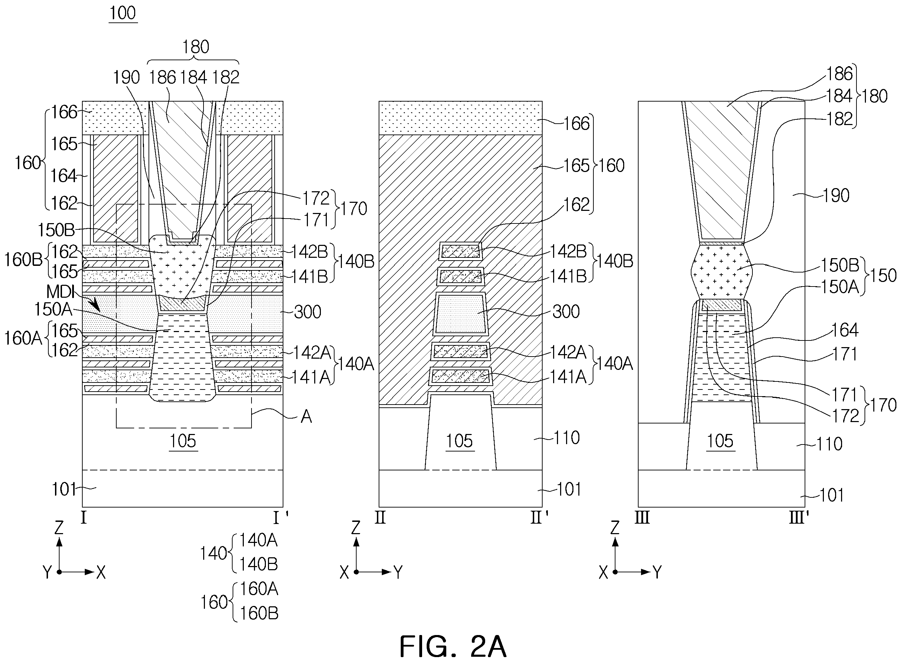

FIG. 2A shows cross-sectional diagrams illustrating a semiconductor device, taken along lines I-I', II-II', and III-III' in FIG. 1.

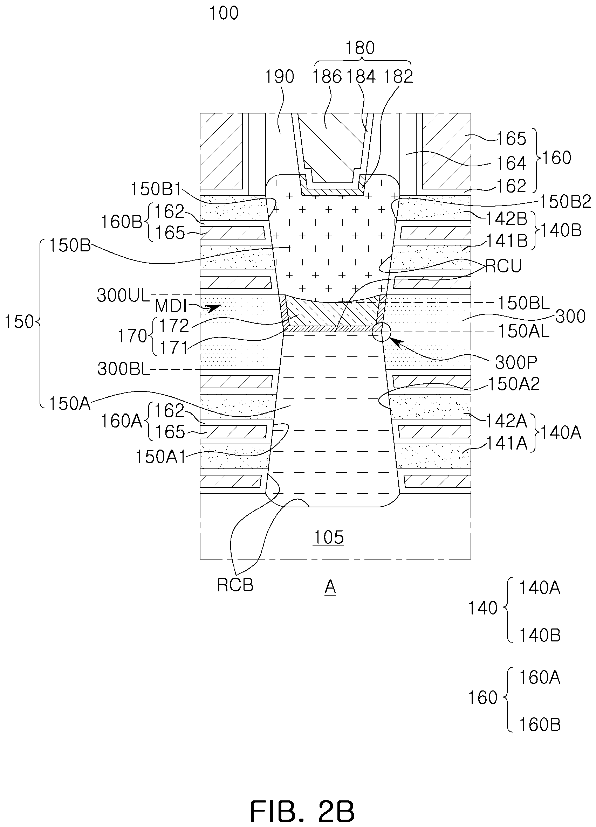

FIG. 2B is an enlarged cross-sectional diagram illustrating a portion of a semiconductor device, illustrating region "A" in FIG. 2A.

For ease of description, FIGS. 1 to 2B illustrate only the main components of the semiconductor device. The structure of the main components of the semiconductor device are described herein with reference to a vertical direction and a horizontal direction. As discussed herein, a vertical direction may be a direction perpendicular to an upper surface of a substrate of the semiconductor device, (e.g., Z-direction). Similarly, a direction may be a direction parallel to the upper surface of the substrate (e.g. X-direction or Y-direction). It will be appreciated that these directions are relative to the structure of the semiconductor device, and need not limit the orientation of the semiconductor device in use. Features that are described as "above" other features may be located further along the vertical direction (e.g. further from the substrate) than the other features. An "upper" portion of a component may be located above other portions of a component (e.g. lower portion(s)). Similarly, an "uppermost" section of a component may be a section of the component that is furthest along the vertical direction (e.g. furthest from the substrate), and a "lowermost" section of a component may be a section of the component that is least far along the vertical direction (e.g. closest to the substrate).

Referring to FIGS. 1 to 2B, a semiconductor device 100 may include a substrate 101, an active region 105 on the substrate 101, a device isolation layer 110 defining the active region 105, a channel structure 140 including a plurality of channel layers 141A, 142A, 141B, and 142B disposed and spaced apart from each other vertically on active region 105, an intermediate dielectric isolation structure MDI disposed between lower channel layers 141A and 142A and upper channel layers 141B and 142B, a gate structure 160 extending by intersecting the active region 105, source/drain region 150 in contact with the plurality of channel layers 141A, 142A, 141B, and 142B, and a barrier structure 170 disposed between a lower source/drain region 150A and an upper source/drain region 150B.

The semiconductor device 100 may further include a contact structure 180 and an interlayer insulating layer 190. Also, although not illustrated for ease of description, the semiconductor device 100 may further include a contact plug connected to the lower source/drain region 150A.

The substrate 101 may have an upper surface extending in a first direction (e.g. an X-direction) and a second direction (e.g. a Y-direction) (e.g. defining a horizontal plane). The first direction and the second direction may intersect each other (e.g. may be perpendicular to each other). The first direction and the second direction may be parallel to the upper surface of the substrate 101. The substrate 101 may include a semiconductor material, such as a group IV semiconductor, a group III-V compound semiconductor, or a group II-VI compound semiconductor. For example, a group IV semiconductors may include silicon, germanium, or silicon-germanium. The substrate 101 may be provided as a bulk wafer, an epitaxial layer, a silicon on insulator (SOI) layer, or a semiconductor on insulator (SeOI) layer.

The active region 105 may be defined by the device isolation layer 110 in the substrate 101 and may be disposed to extend in the first direction, for example, the X-direction. The active region 105 may have a structure protruding from the substrate 101. An upper end of the active region 105 may be disposed to protrude from the upper surface of the device isolation layer 110 on a predetermined level. The active region 105 may be formed as a portion of the substrate 101 or may include an epitaxial layer grown from the substrate 101. However, the active region 105 on the substrate 101 may be partially recessed on both sides of the gate structure 160, and the source/drain region 150 may be disposed on the recessed active region 105. The active region 105 may include impurities or may include doped regions including impurities. Whilst a single active region 105, a single contact structure 180 and a single source/drain region 150 are shown in FIG. 1, it will be appreciated that the semiconductor device 100 may include a plurality of active regions 105 (e.g. spaced apart from each other in the second direction), a plurality of contact plugs 180 and a plurality of source/drain regions 150 (e.g. spaced apart from each other in the first and second directions). The below description of each individual component may equally apply to other instances of this component in the semiconductor device.

In the semiconductor device 100, the active region 105 may have a fin structure, and the gate structure 160 may be disposed between the active region 105 and the channel structure 140, between the lower channel layers 140A and the upper channel layers 140B of the channel structure 140, and on the channel structure 140. Accordingly, the semiconductor device 100 may include transistors having a multi-bridge-channel FET (MBCFET^{™}) structure, which is a gate-all-around type field effect transistor (FET). In some implementations, a semiconductor device may include transistors of a complementary FET (CFET) structure. The example implementation may also be applied to a transistor having a three dimensional - stacked FET (3D-SFET) structure in which a plurality of transistors is vertically stacked.

As illustrated in FIG. 2A, the semiconductor device 100 according to the example implementation may include a first transistor structure TR1 and a second transistor structure TR2 stacked on the active regions 105. The first and second transistor structures TR1 and TR2 employed in the example implementation may be a multi-bridge-channel FET (MBCFET^{™}) including a gate structure 160 surrounding the lower channel layers 141A and 142A and the upper channel layers 141B and 142B disposed on the active region 105. Each of the first transistor structures TR1 may be one of an N-type MOSFET and a P-type MOSFET, and the second transistor structures TR2 may be one of a P-type MOSFET and an N-type MOSFET. In some example implementations, each of the first and second transistor structures TR1 and TR2 may be a P-type MOSFET and an N-type MOSFET, respectively.

The device isolation layer 110 may define the active region 105 in the substrate 101. The device isolation layer 110 may be formed by, for example, a shallow trench isolation (STI) process. In example implementations, the device isolation layer 110 may further include a region further extending downwardly to a region below the substrate 101 while having a step difference. The device isolation layer 110 may partially expose an upper portion of the active region 105. In example implementations, the device isolation layer 110 may have a curved upper surface having a level increasing toward the active region 105. The device isolation layer 110 may be formed of an insulating material. The device isolation layer 110 may be, for example, an oxide, nitride, or a combination thereof.

In the example implementation, the first and second transistor structures TR1 and TR2 may be configured to share a gate structure 160.

Specifically, the first transistor structure TR1 may include lower channel layers 141A and 142A stacked on the active region 105, a gate electrode 165 surrounding the lower channel layers 141A and 142A, lower source/drain region 150A connected to lower channel layers 141A and 142A on one side of the gate electrode 165, and a gate dielectric layer 162 disposed between lower channel layers 141A and 142A and gate electrode 165.

Similarly, the second transistor structure TR2 may include upper channel layers 141B and 142B, gate electrode 165 surrounding the upper channel layers 141B and 142B, upper source/drain region 150B connected to the upper channel layers 141B and 142B on both sides of the gate electrode 165, and a gate dielectric layer 162 disposed between the upper channel layers 141B and 142B and the gate electrode 165.

The channel structure 140 may include two or more of a plurality of channel layers 141A, 142A, 141B, and 142B spaced apart from each other in a direction perpendicular to an upper surface of the active region 105, for example, in the Z-direction, on the active region 105, that is, a lower channel structure 140A including lower channel layers 141A and 142A and an upper channel structure 140B including upper channel layers 141B and 142B. The plurality of channel layers 141A, 142A, 141B, and 142B may be connected to source/drain region 150 and may be spaced apart from the upper surface of active region 105. The upper channel layers 141B and 142B may be disposed on the intermediate insulating structure MDI, and may be spaced apart from each other in the Z-direction.

The plurality of channel layers 141A, 142A, 141B, and 142B may have a width the same as or similar to that of the active region 105 in the Y-direction. In example implementations, widths of the plurality of channel layers 141A, 142A, 141B, and 142B in the Y-direction may decrease in a direction away from the upper surface of the substrate 101 (e.g. in the vertical direction). Widths of the plurality of channel layers 141A, 142A, 141B, and 142B in the X-direction may increase and decrease thereafter toward an upper surface of substrate 101. For example, the width of upper channel layers 141B and 142B in the X-direction may increase toward the upper surface of substrate 101, and widths of lower channel layers 141A and 142A in the X-direction may decrease toward the upper surface of substrate 101, which may be due to the shapes of the lower recess region RCB and the upper recess region RCU.

The plurality of channel layers 141A, 142A, 141B, and 142B may be formed of a semiconductor material, and may include, for example, at least one of silicon (Si), silicon germanium (SiGe), and germanium (Ge). For example, the plurality of channel layers 141A, 142A, 141B, and 142B may be formed of the same material as that of the substrate 101. The plurality of channel layers 141A, 142A, 141B, and 142B may be disposed and spaced apart from each other vertically on the active region 105. The number of the plurality of channel layers 141A, 142A, 141B, and 142B included in the channel structure 140 and the shapes thereof may vary in example implementations.

The intermediate insulating structure MDI may be disposed between the uppermost lower channel layer 142A among the lower channel layers 141A and 142A and the lowermost upper channel layer 141B among the upper channel layers 141B and 142B. The intermediate insulating structure MDI may include intermediate insulating pattern 300. The intermediate insulating pattern 300 may include an insulating material such as an oxide, nitride and oxynitride. The intermediate insulating structure MDI may allow the lower channel layers 141A and 142A to be spaced apart from the upper channel layers 141B and 142B. The intermediate insulating structure MDI may include a protrusion 300P protruding toward the barrier structure 170. In example implementations, the protrusion 300P may also be referred to as an intermediate portion 300P. The protrusion 300P may have a tip shape (e.g. a pointed shape), but an example implementation thereof is not limited thereto. In another example implementation, the protrusion 300P may have a rounded shape, rounded toward the barrier structure 170.

The gate structures 160 may intersect the active region 105, may surround the lower channel layers 141A and 142A and upper channel layers 141B and 142B, respectively, and may extend in the second direction Y. The lower gate structure 160A may intersect the active region 105, may surround the lower channel layers 141A and 142A, respectively, may extend in the second direction Y, and may be disposed below the lower surface of the intermediate insulating structure MDI. The upper gate structure 160B may surround the upper channel layers 141B and 142B, respectively, may extend in the second direction Y, and may be disposed on the upper surface of the intermediate insulating structure MDI. In the example implementation, as described above, the first and second transistor structures TR1 and TR2 may share the gate structure 160. The gate electrode 165 employed in the example implementation may work as a common gate electrode surrounding the plurality of channel layers 141A, 142A, 141B, and 142B. The gate dielectric layer 162 may be provided between the lower channel layers 141A and 142A and the gate electrode 165, and also between the upper channel layers 141B and 142B and the gate electrode 165. The gate dielectric layer 162 may surround the intermediate insulating pattern 300 in the second direction (e.g., Y-direction). The gate structure 160 may further include gate spacer layers 164. The gate spacer layers 164 may be disposed on both sidewalls of the electrode portion extending in the second direction (e.g., Y-direction) on the uppermost upper channel layers 141B and 142B among the gate electrode 165. The gate capping layer 166 may be formed on the gate spacer layers 164 and the gate electrode 165.

The gate electrode 165 employed in the example implementation may include a conductive material. For example, the gate electrode 165 may include at least one of W, Ti, Ta, Mo, TiN, TaN, WN, TiON, TiAlC, TiAlN, and TaAlC. The gate electrode 165 may include a semiconductor material such as doped polysilicon. The common gate electrode 165 may include multiple (e.g. two or more) layers. Although not illustrated, in another example implementation, an inter-gate insulating layer isolating the upper gate structure 160B from the lower gate structure 160A on substantially the same level as a level of the intermediate insulating structure MDI may be further included. At least a portion of the inter-gate insulating layer may be disposed to overlap the intermediate insulating structure MDI in the horizontal direction. Due to the inter-gate insulating layer, the gate electrode 165 of the upper gate structure 160B and the gate electrode 165 of the lower gate structure 160A may include different conductive materials. The gate electrode 165 of the upper gate structure 160B and the gate electrode 165 of the lower gate structure 160A may be formed of a material having an appropriate work function in consideration of a desired threshold voltage. Similarly, the gate dielectric layer 162 of the upper gate structure 160B and the gate dielectric layer 162 of the lower gate structure 160A may include different dielectric layers or a combination thereof.

For example, each of the gate dielectric layer 162 may include an oxide, nitride, or high-κ material. The high-κ material may refer to a dielectric material having a higher dielectric constant than that of silicon oxide (SiO₂). The high-κ material may be, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

For example, the gate spacer layers 164 may include at least one of silicon oxide, silicon nitride, and silicon oxynitride. In some example implementations, the gate spacer layers 164 may include a multilayer structure. The gate capping layer 166 may include, for example, silicon nitride, silicon oxynitride, silicon carbonitride, or silicon oxycarbonitride.

In some implementations, a slope of the side surface of the lower source/drain region 150A and a slope of the side surface of the upper source/drain region 150B may have slopes of opposite signs. The sign of a given slope may represent a change in the position along a horizontal direction (in this case, the first direction X) for a given change in height. For instance, a positive slope may result in a slope forward along the first direction (e.g. the position along the first direction increasing with increasing vertical position), whereas a negative slope may result in a slope backward in a direction opposite to the first direction (e.g. the position along the first direction decreasing with increasing vertical position). The side surface of the lower source/drain region 150A may include a first lower inclined surface 150A1 and a second lower inclined surface 150A2. The second lower inclined surface 150A2 may be located opposite the first lower inclined surface 150A1 in the first direction. The second lower inclined surface 150A2 may be further along the first direction than the first lower inclined surface 150A1. The side surface of the upper source/drain region 150B may include a first upper inclined surface 150B1 and a second upper inclined surface 150B2. The second upper inclined surface 150B2 may be located opposite the first upper inclined surface 150B 1 in the first direction. The second upper inclined surface 150B2 may be further along the first direction than the first upper inclined surface 150B1. For example, the first lower inclined surface 150A1 and the second lower inclined surface 150A2 may have a positive slope and a negative slope, respectively, and the first upper inclined surface 150B1 and the second upper inclined surface 150B2 may have a negative slope and positive slope, respectively. Accordingly, the width of the lower gate structure 160A in the first direction X may decrease toward the upper surface of the substrate 101, and the width of the upper gate structure 160B may decrease in the first direction X in a direction away from the upper surface of the substrate 101. Accordingly, the width of the lower source/drain region 150A may increase toward the upper surface of the substrate 101, and the width of the upper source/drain region 150B may decrease toward the upper surface of the substrate 101.

The lower source/drain region 150A may be disposed on the active region 105 on at least one side of the gate structures 160 and may be connected to side surfaces of the lower channel layers 141A and 142A. The lower source/drain region 150A may be provided as a source region or a drain region of the first (lower) transistor structure TR1. The lower source/drain region 150A may include epitaxial growth from the surface of the recessed portion of the active region 105 and both side surfaces of the lower channel layers 141A and 142A. Similarly, the upper source/drain region 150B may be connected to the side surface of the upper channel layers 141B and 142B on at least one side of the gate structures 160 and may be spaced apart from the lower source/drain region 150A in the vertical direction. The upper source/drain region 150B may be provided as a source region or a drain region of the second (upper) transistor structure TR2. The upper source/drain region 150B may include epitaxial growth using both side surfaces of the upper channel layers 141B and 142B as seed layers.

The lower and upper source/drain regions 150A and 150B may include a semiconductor (e.g. an epitaxial semiconductor) such as silicon (Si). The lower and upper source/drain regions 150A and 150B may include impurities of different types and/or concentrations. For example, when the first transistor structure TR1 is a P-type MOSFET, the upper source/drain region 150A may include P-type doped silicon germanium (SiGe), and when the second transistor structure TR2 is an N-type MOSFET, the upper source/drain region 150B may include N-type doped silicon (Si). Accordingly, the cross-sectional surface in the second direction (e.g., Y-direction) of the lower and upper source/drain regions 150A and 150B may have different shapes. For example, the cross-sectional surfaces of the lower and upper source/drain regions 150A and 150B may have circular, oval, pentagonal, hexagonal shapes or shapes similar thereto. In example implementations, since the lower source/drain region 150A is formed between the gate spacer layers 164 and the first barrier pattern 171, the cross-sectional surface of the lower source/drain region 150A in the Y-direction may have a trapezoidal shape of which a width may increase toward the upper surface of substrate 101. As discussed herein a cross-section in a particular direction (e.g. in the X-direction) may be a cross-section taken by viewing a structure along the particular direction (e.g. a cross-section taken by slicing along a plane perpendicular to the particular direction). When referring to a cross-sectional surface of an object or component in a particular direction, this may refer to the shape of the object or component when viewed in a cross-section taken along that particular direction.

The lower source/drain region 150A may fill the lower recess region RCB defined by the side surface of the lower channel layers 141A and 142A, the side surface of the gate structures 160, and the upper surface of the active region 105. The upper source/drain region 150B may fill the upper recess region RCU defined by the side surface of upper channel layers 141B and 142B, the side surface of gate structures 160, and the lower surface and side surface of barrier structure 170. For example, the intermediate portion 300P may be a portion in which the side surface of the lower recess region RCB and the side surface of the upper recess region RCU meet each other. Also, the intermediate portion 300P may be a portion in which the side surface of the lower source/drain region 150A and the side surface of the upper source/drain region 150B may extend and meet each other. In example implementations, the intermediate portion 300P may be an area where the sign of the slope of the side of the source/drain region 150 is reversed. For example, the side of the source/drain region 150 may change from a positive slope to a negative slope in the vertical direction in the intermediate potion 300P. In example implementations, the slope of the side surface of the lower recess region RCB and the slope of the side surface of the upper recess region RCU may have opposite signs. The intermediate portion 300P may be a concave potion formed by contacting the side surface of the lower recess area RCB and the side surface of the upper recess area RCU. The level of the intermediate portion 300P may be substantially equal to or lower than a level 300UL of the upper surface of the intermediate insulating structure MDI and may be substantially equal to or higher than the level 300BL of the lower surface of the intermediate insulating structure MDI. The level of the intermediate portion 300P may be substantially the same as or higher than the level of the uppermost surface of the lower gate structure 160A, which is disposed below the lower surface of the intermediate insulating structure MDI, and may be substantially the same as or lower than the level of the lowermost surface of the upper gate structure 160B disposed on the upper surface of the intermediate insulating structure MDI. The level 150BL of the lowermost end of the upper source/drain region 150B may be lower than the level 300UL of the uppermost surface of the intermediate insulating structure MDI. The level 150AL of the upper end of lower source/drain region 150A may be disposed on a level substantially equal to or higher than a level of level 300BL of the lower surface of the intermediate insulating structure MDI. The upper portion of the lower source/drain region 150A may overlap the intermediate insulating structure MDI horizontally.

In example implementations, the lower source/drain region 150A may include a first lower inclined surface 150A1 and a second lower inclined surface 150A2, which has a slope different from the first lower inclined surface 150A1, of which widths in the X-direction may increase downwardly from the upper portion of the lower source/drain region 150A may be inclined. The upper source/drain region 150B may include a first upper inclined surface 150B1 and a second upper inclined surface 150B2 inclined in a direction different from that of the first upper inclined surface 150B1, of which widths in the X-direction may decrease downwardly from the upper portion of the upper source/drain region 150B may be inclined. Accordingly, the cross-sectional surfaces of the lower and upper source/drain regions 150A and 150B in the X-direction may have a trapezoidal shape (the wider base of the trapezoid being closer to the substrate than the narrower base of the trapezoid) and an inverted trapezoidal shape (the wider base of the trapezoid being further from the substrate than the narrower base of the trapezoid), respectively.

The barrier structure 170 may be disposed between the lower source/drain region 150A and the upper source/drain region 150B. The barrier structure 170 may vertically overlap the lower source/drain region 150A and the upper source/drain region 150B. The upper surface of barrier structure 170 may have a downwardly convex shape, but an example implementation thereof is not limited thereto. As illustrated in FIG. 2A, the lower surface of the barrier structure 170 may have a flat shape, but an example implementation thereof is not limited thereto. In another example implementation, the lower surface of the barrier structure 170 may have a shape convex upwardly or convex downwardly. The barrier structure 170 may include a first barrier pattern 171 and a second barrier pattern 172 on the first barrier pattern 171 formed along the lower portion and the lower surface of the side surface of the upper recess region RCU. The first and second barrier patterns 171, 172 may include an insulating material such as an oxide, nitride, or oxynitride. The first and second barrier patterns 171 and 172 may include different materials, but an example implementation thereof is not limited thereto. The barrier structure 170 may isolate the lower source/drain region 150A and the upper source/drain region 150B from each other in the vertical direction Z.

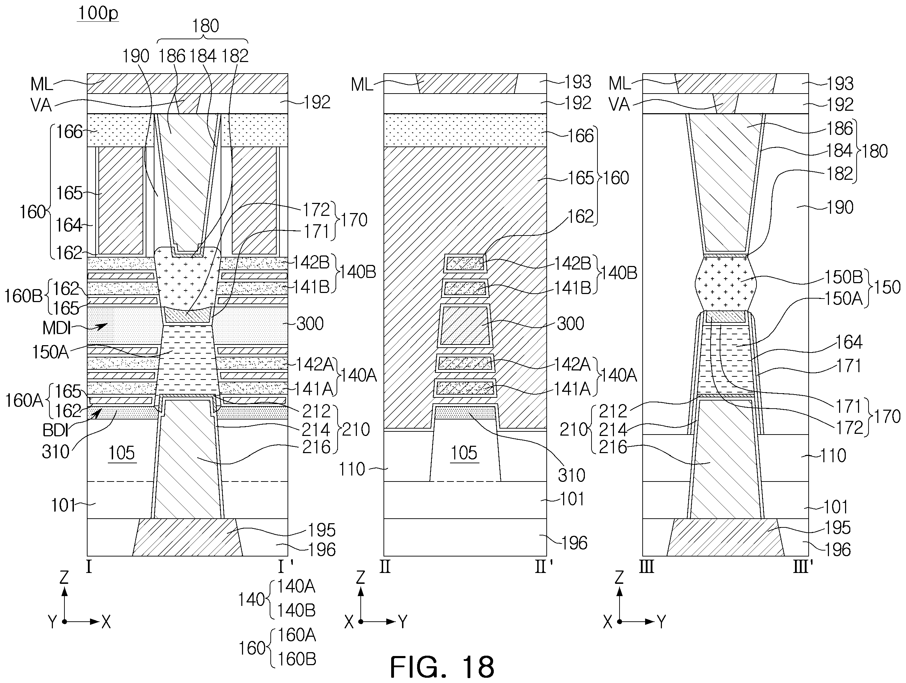

The contact structure 180 may penetrate through at least a portion of the interlayer insulating layer 190, may be in contact with the source/drain region 150, and may apply an electrical signal to the source/drain region 150. The contact structure 180 may be in contact with the upper portion of the upper source/drain region 150B. Although not illustrated for ease of description, a contact plug connected to the lower source/drain region 150A may be further included. The contact plug connected to the lower source/drain region 150A may include a horizontal contact portion extending in the direction (e.g., Y-direction) horizontal to the upper surface of the substrate 101, and a vertical contact portion connected to the horizontal contact portion and extending in a direction perpendicular to the upper surface of the substrate 101 (e.g., Z-direction). The horizontal contact portion may be disposed on the upper surface of the lower source/drain region 150A, and the vertical contact portion may penetrate through the interlayer insulating layer 190. The contact plug may include substantially the same material as that of the contact structure 180. However, the contact plug is not limited to the above structure and may have various shapes. For example, the contact plug may have the structure the same as the backside contact structure 210 of the semiconductor device 100p in FIG. 18.

The contact structure 180 may be disposed on the source/drain region 150, and in example implementations, the contact structure 180 may be disposed to have a longer length in the Y-direction than that of the source/drain region 150. The contact structure 180 may have an inclined side surface on which a width of the lower portion may decrease further than a width of the upper portion depending on an aspect ratio, but an example implementation thereof is not limited thereto. The contact structure 180 may be disposed to be recessed into the source/drain region 150 to a predetermined depth.

The contact structure 180 may include a first metal-semiconductor compound layer 182 disposed on a lower end, a barrier layer 184 disposed along sidewalls, and a plug conductive layer 186. The first metal-semiconductor compound layer 182 may be, for example, a metal silicide layer. The barrier layer 184 may include a metal nitride, for example, titanium nitride (TiN), tantalum nitride (TaN), or tungsten nitride (WN). The plug conductive layer 186 may include, a metal material, for example aluminum (Al), tungsten (W), or molybdenum (Mo). In example implementations, the contact structure 180 may be disposed to penetrate through at least a portion of the source/drain region 150. In example implementations, the number of the conductive layers included in the contact structure 180 and arrangement thereof may be changed in various manners. Also, a wiring structure such as a contact structure may be further disposed on the gate electrode 165, and a wiring structure connected to the contact structure 180 may be further disposed on the contact structure 180.

The interlayer insulating layer 190 may be disposed to cover the source/drain region 150, the gate structure 160 and the device isolation layer 110. The interlayer insulating layer 190 may include, for example, at least one of an oxide, nitride, oxynitride and low-k dielectric.

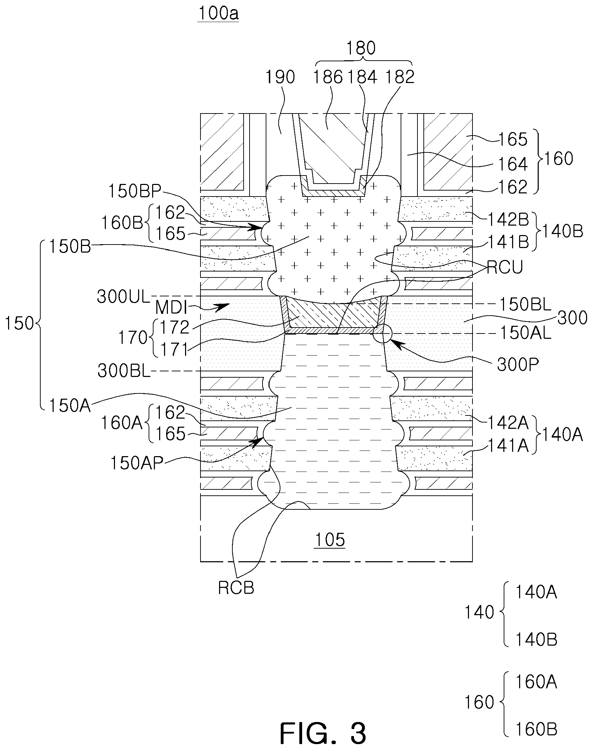

FIG. 3 is an enlarged cross-sectional diagram illustrating a portion of a semiconductor device according to example implementations, illustrating a region corresponding to FIG. 2B.

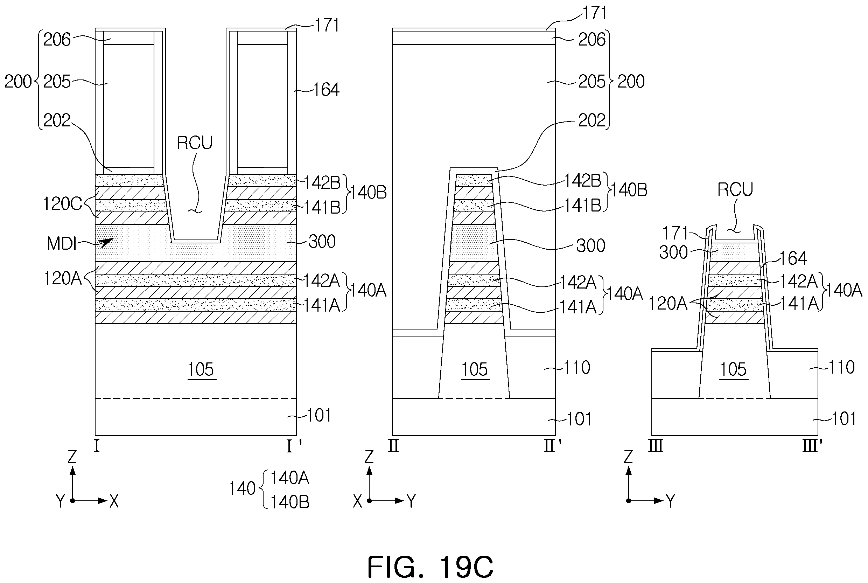

Referring to FIG. 3, in a semiconductor device 100a, the lower source/drain region 150A may be recessed into a portion of the active region 105 and may include a lower source/drain protrusion region 150AP (e.g. one or more lower source/drain protrusions) protruding toward the lower gate structure 160A, and the upper source/drain region 150B may include an upper source/drain protrusion region 150BP (e.g. one or more upper source/drain protrusions) protruding toward the upper gate structure 160B. The upper source/drain protrusion region 150BP may be formed by forming an upper recess region RCU, further forming the upper recess region RCU in the horizontal direction through a wet etching process, and forming the upper source/drain region 150B in the upper recess region RCU in the process in FIG. 19C. The lower source/drain protrusion region 150AP may be formed by forming the lower recess region RCB, further forming the lower recess region RCB in the horizontal direction through a wet etching process, and forming the lower source/drain region 150A in the lower recess region RCB. The forming the lower source/drain protrusion region 150AP and forming the upper source/drain protrusion region 150BP may be independent of each other.

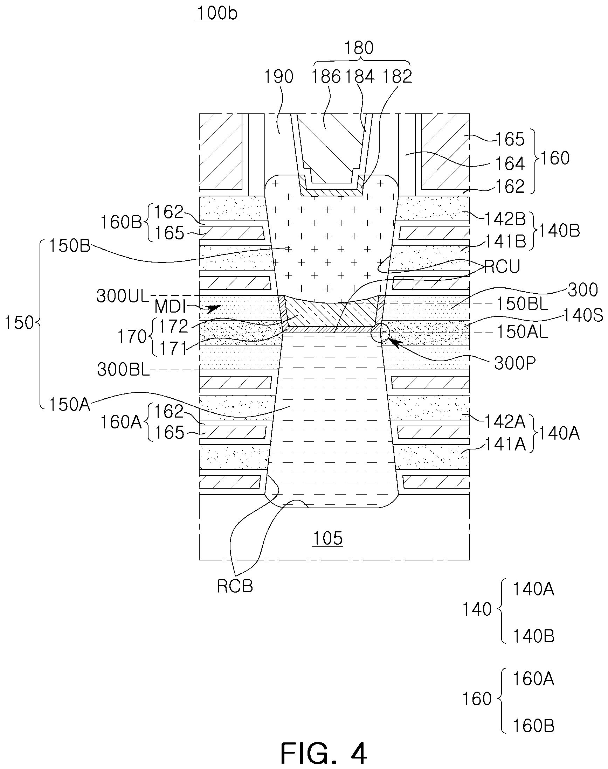

FIG. 4 is an enlarged cross-sectional diagram illustrating a portion of a semiconductor device according to example implementations, illustrating the region corresponding to FIG. 2B.

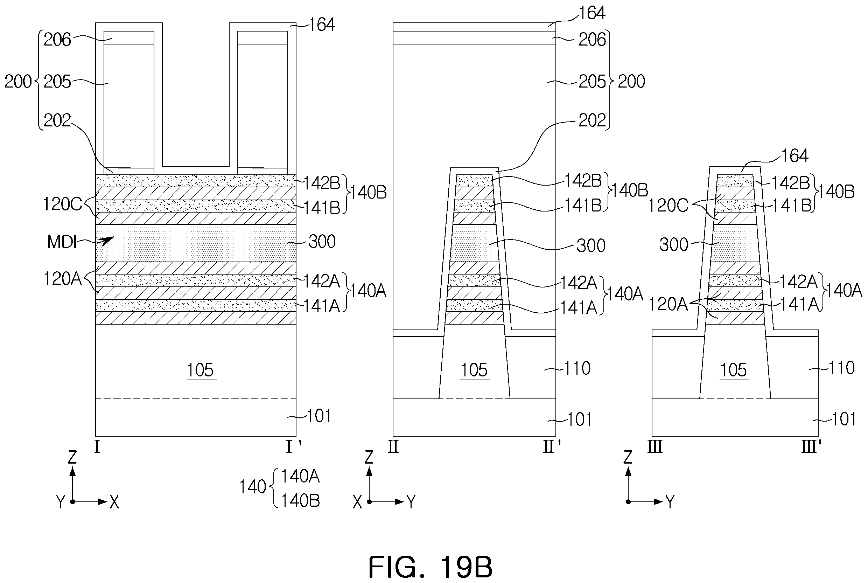

Referring to FIG. 4, in a semiconductor device 100b, the intermediate insulating structure MDI may include a semiconductor pattern 140S between the plurality of intermediate insulating patterns 300 and the plurality of intermediate insulating patterns 300. The semiconductor pattern 140S may include silicon (Si) or silicon germanium (SiGe). The semiconductor pattern 140S may have etch selectivity for the plurality of channel layers 141A, 142A, 141B, and 142B, the lower sacrificial layers 120A, the intermediate sacrificial layers 120B, and the upper portion sacrificial layers 120C. The semiconductor pattern 140S may remain when the intermediate sacrificial layers 120B are removed in the process in FIG. 19B, which will be described later. Accordingly, the semiconductor pattern 140S may be disposed between the intermediate insulating patterns 300.

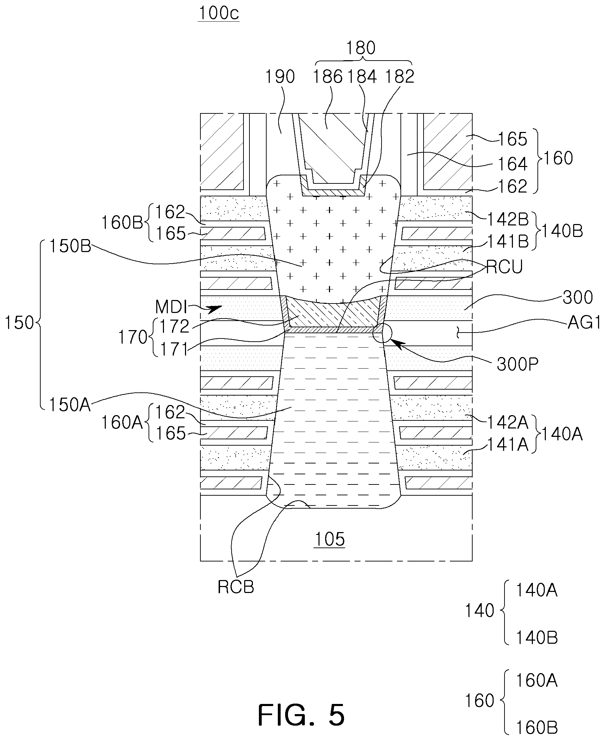

FIG. 5 is an enlarged cross-sectional diagram illustrating a portion of a semiconductor device according to example implementations, illustrating the region corresponding to FIG. 2B.

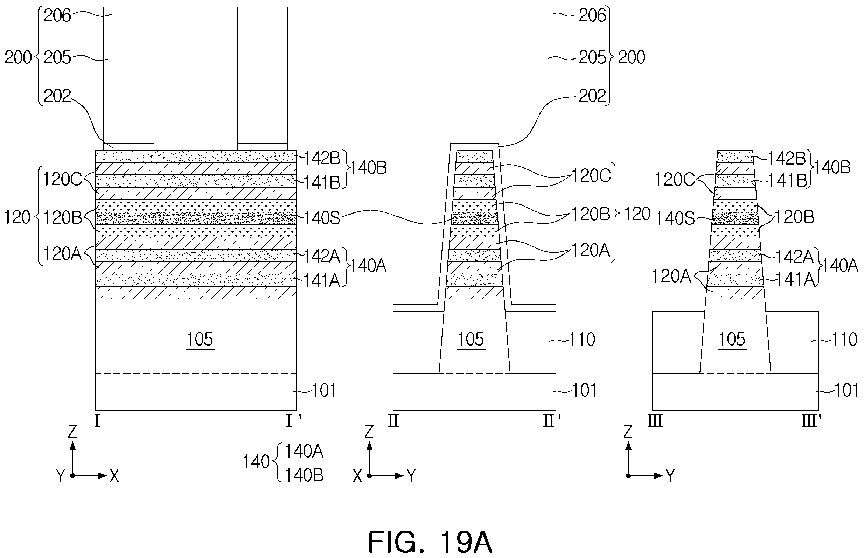

Referring to FIG. 5, in a semiconductor device 100c, the intermediate insulating structure MDI may include a first air gap AG1. The first air gap AG1 may vertically overlap the lower gate structure 160A and the upper gate structure 160B. The first air gap AG1 may be formed in a region corresponding to the semiconductor pattern 140S in FIG. 19A. In example implementations, the semiconductor pattern 140S may not be replaced by intermediate insulating pattern 300, and the semiconductor pattern 140S may be selectively removed in a subsequent process, thereby forming the first air gap AG1. The first air gap AG1 may include a gas consisting of air or materials used in the semiconductor device 100c manufacturing process, which may also be applied to another example implementation.

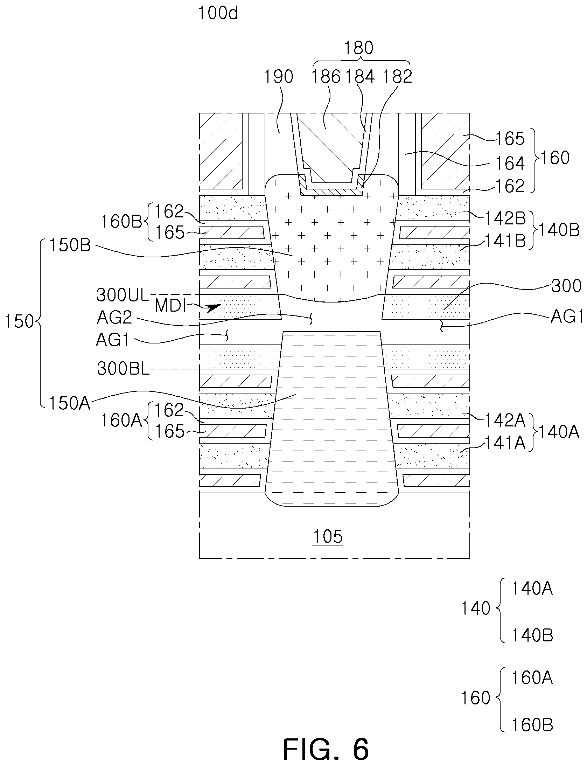

FIG. 6 is an enlarged cross-sectional diagram illustrating a portion of a semiconductor device according to example implementations, illustrating a region corresponding to FIG. 2B.

Referring to FIG. 6, a semiconductor device 100d may include a second air gap AG2 in the semiconductor device 100c in FIG. 5. For example, the barrier structure 170 may not include a first barrier pattern 171 and a second barrier pattern 172, and may include a second air gap AG2. The second air gap AG2 may vertically overlap a lower source/drain region 150A and an upper source/drain region 150B. The second air gap AG2 may be formed by selectively removing the first barrier pattern 171 and the second barrier pattern 172 through the first air gap AG1 in addition to the process of manufacturing the semiconductor device 100c in FIG. 5. Accordingly, the first air gap AG1 and the second air gap AG2 may be connected to each other. The second air gap AG2 may include a gas consisting of air or materials used in the process of manufacturing the semiconductor device 100, which may also be applied to another example implementation.

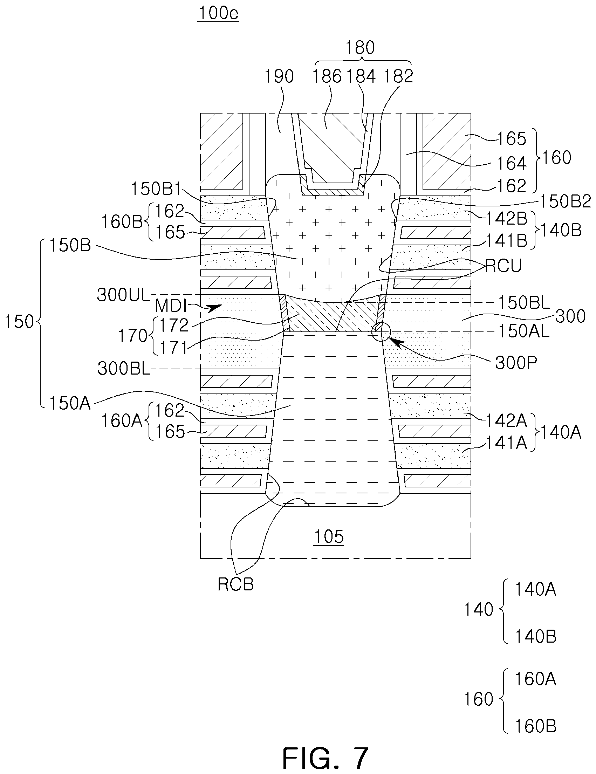

FIG. 7 is an enlarged cross-sectional diagram illustrating a portion of a semiconductor device according to example implementations, illustrating the region corresponding to FIG. 2B.

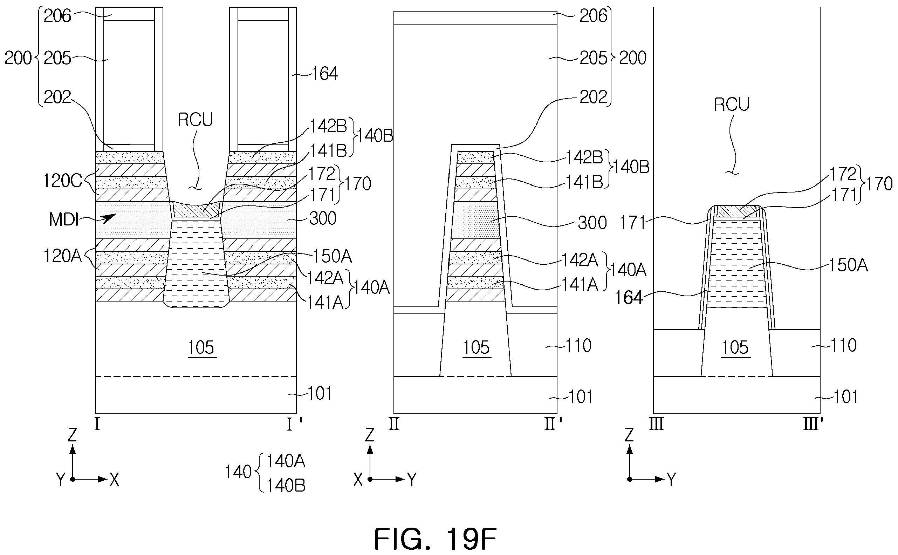

Referring to FIG. 7, in a semiconductor device 100e, the second barrier pattern 172 may cover an upper surface of the lower source/drain region 150A. In the process of performing the process in FIG. 19F described later, the process of covering the upper surface of the lower source/drain region 150A with the first barrier pattern 171 may not be performed, and the second barrier pattern 172 may be formed to be in contact with the upper surface of the lower source/drain region 150A. Accordingly, the first barrier pattern 171 may be disposed on the side surface of the second barrier pattern 172.

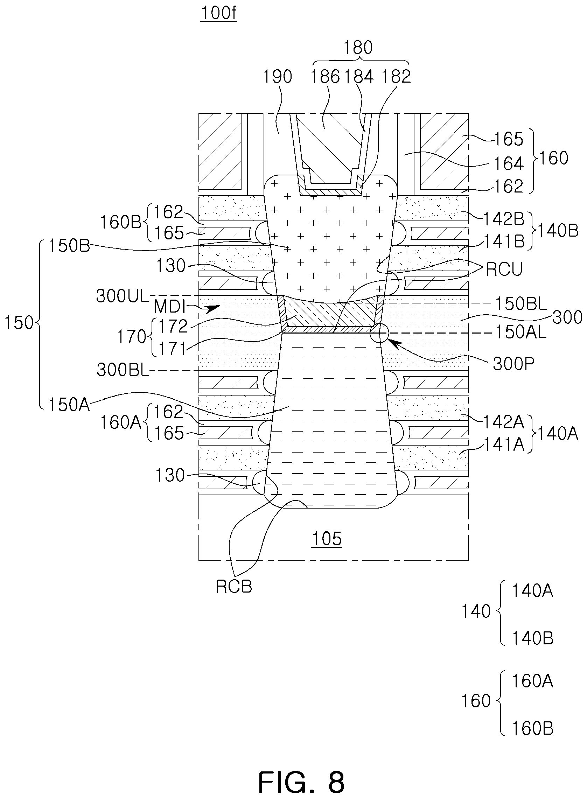

FIG. 8 is an enlarged cross-sectional diagram illustrating a portion of a semiconductor device according to example implementations, illustrating the region corresponding to FIG. 2B.

Referring to FIG. 8, a semiconductor device 100f may further include internal spacer layers 130 disposed on both sides of the gate structure 160 in the first direction on the lower surface of each of the plurality of channel layers 141A, 142A, 141B, and 142B and the lower surface of intermediate insulating structure MDI, differently from the example implementation in FIG. 2A. In example implementations, the internal spacer layers 130 may be in contact with at least one of the lower source/drain region 150A and the upper source/drain region 150B. The internal spacer layers 130 may be disposed in parallel with the gate electrode 165 between the plurality of channel layers 141A, 142A, 141B, and 142B. The internal spacer layers 130 may be in contact with the gate dielectric layer 162. The internal spacer layers 130 may be disposed between the gate structure 160 and the source/drain region 150. A side surface of the internal spacer layers 130 may be in contact with the source/drain region 150. The gate electrode 165 may be electrically isolated from the source/drain region 150 by the internal spacer layers 130. A side surface of the internal spacer layers 130 opposing the gate electrode 165 may have a shape rounded outwardly toward the gate electrode 165. The internal spacer layers 130 may be formed of an oxide, nitride and oxynitride, and may be formed by a low dielectric constant film, for example.

The internal spacer layers 130 may be formed of the same material as that of the gate spacer layers 164, but an example implementation thereof is not limited thereto. For example, the internal spacer layers 130 may include at least one of SiN, SiCN, SiOCN, SiBCN, and SiBN. The internal spacer layers 130 may also be applied to the other example implementations.

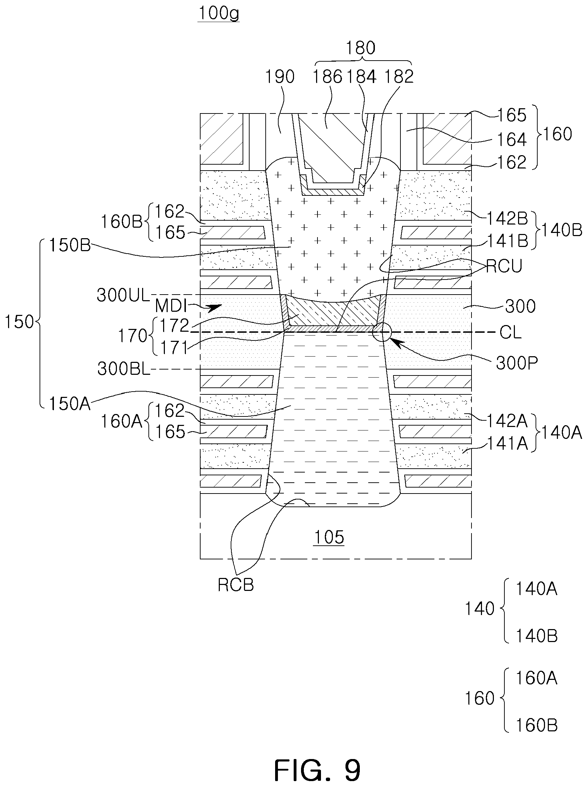

FIG. 9 is an enlarged cross-sectional diagram illustrating a semiconductor device according to example implementations, illustrating a region corresponding to FIG. 2B.

Referring to FIG. 9, in the semiconductor device 100g, the shape of the lower source/drain region 150A may be symmetrical to the shape formed by combining the intermediate insulating structure MDI and the upper source/drain region 150B with respect to the surface CL in which the barrier structure 170 and the lower source/drain region 150A meet each other. In example implementations, the upper recess region RCU and the lower recess region RCB may be symmetrical with respect to the surface CL on which the barrier structure 170 and the lower source/drain region 150A meet each other, which may be because the thickness of the uppermost channel layer 142B among the upper channel layers 141B and 142B is configured to be greater than the thickness of the upper channel layers 141B other than the lower channel layers 141A and 142A and uppermost channel layer 142B, but an example implementation thereof is not limited thereto. The symmetry described above may ignore the contact structure 180 penetrating into the upper source/drain region 150B. For instance, the symmetry may apply to the upper surface and side surfaces of the lower source/drain region 150A.

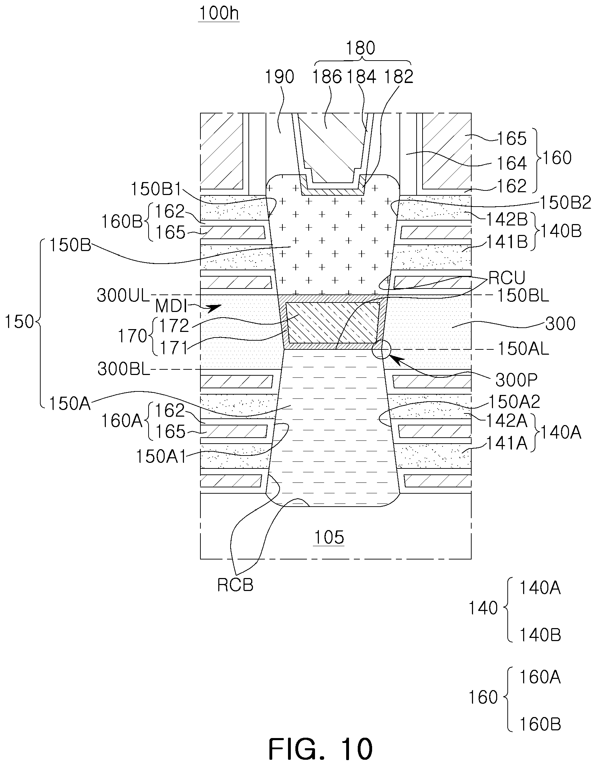

FIG. 10 is an enlarged cross-sectional diagram illustrating a portion of a semiconductor device according to example implementations, illustrating the region corresponding to FIG. 2B.

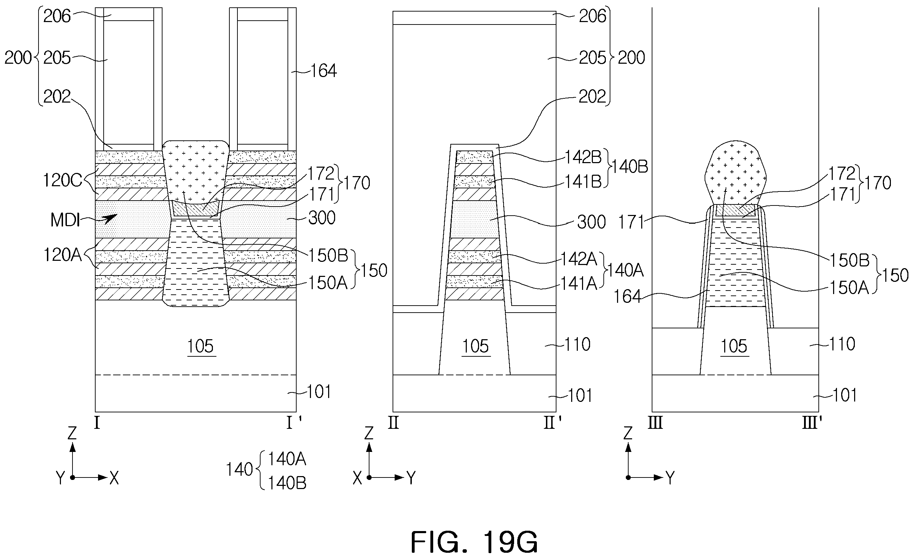

Referring to FIG. 10, in the semiconductor device 100h, the barrier structure 170 may be formed in a structure in which the first barrier pattern 171 surrounds the second barrier pattern 172. The first barrier pattern 171 may surround the upper surface, the lower surface, and the side surface of the second barrier pattern 172. The first barrier pattern 171 may be disposed between the upper surface of the second barrier pattern 172 and the lower surface of the upper source/drain region 150B. The first barrier pattern 171 may be formed on the second barrier pattern 172 before forming the upper source/drain region 150A in FIG. 19G, which will be described later, but an example implementation thereof is not limited thereto. The first barrier pattern 171 may be formed to fill a space between the second barrier pattern 172 and the upper source/drain region 150A after forming the upper source/drain region 150A. The structure of barrier structure 170 as above may also be applied to another example implementation.

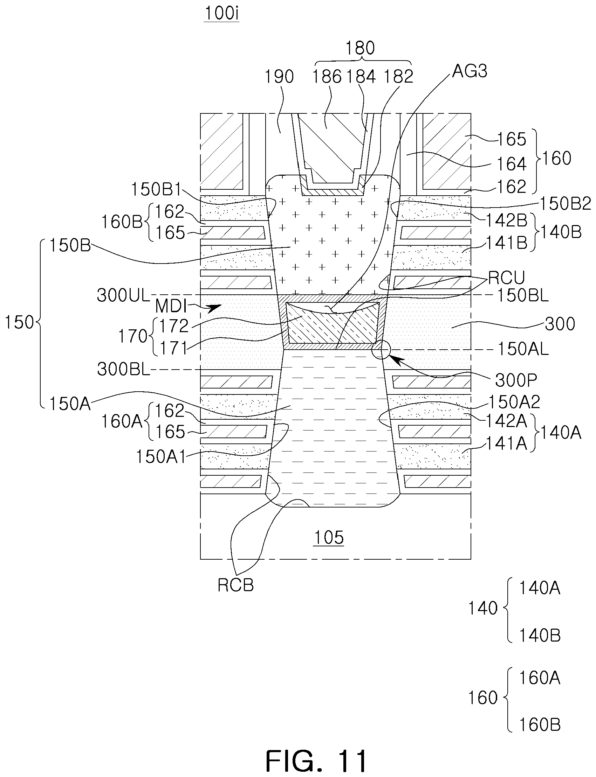

FIG. 11 is an enlarged cross-sectional diagram illustrating a portion of a semiconductor device according to example implementations, illustrating a region corresponding to FIG. 2B.

Referring to FIG. 11, a semiconductor device 100i may further include a third air gap AG3 between the second barrier pattern 172 and the first barrier pattern 171. When the second barrier pattern 172 is formed to be convex downwardly, and the first barrier pattern 171 does not completely fill the space between the second barrier pattern 172 and the upper source/drain region 150B, the third air gap AG3 may be formed. The third air gap AG3 may include gas consisting of air or materials used in the process of manufacturing the semiconductor device 100i, which may also be applied to another example implementation.

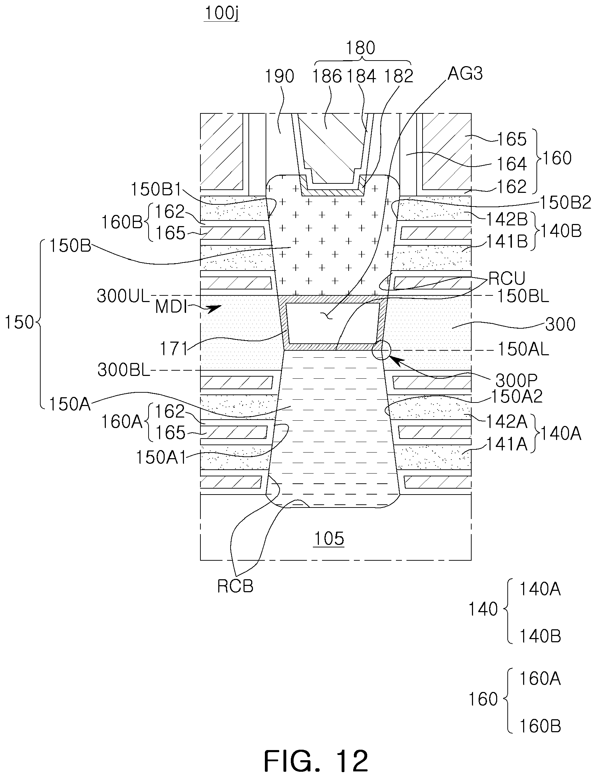

FIG. 12 is an enlarged cross-sectional diagram illustrating a semiconductor device according to example implementations, illustrating a region corresponding to FIG. 2B.

Referring to FIG. 12, the semiconductor device 100j may not include the second barrier pattern 172, and may include a third air gap AG3 surrounded by the first barrier pattern 171. By removing the second barrier pattern 172 and forming the first barrier pattern 171, the third air gap AG3 surrounded by the first barrier pattern 171 may be formed. The first barrier pattern 171 and third air gap AG3 may electrically insulate the upper source/drain region 150B from the lower source/drain region 150A.

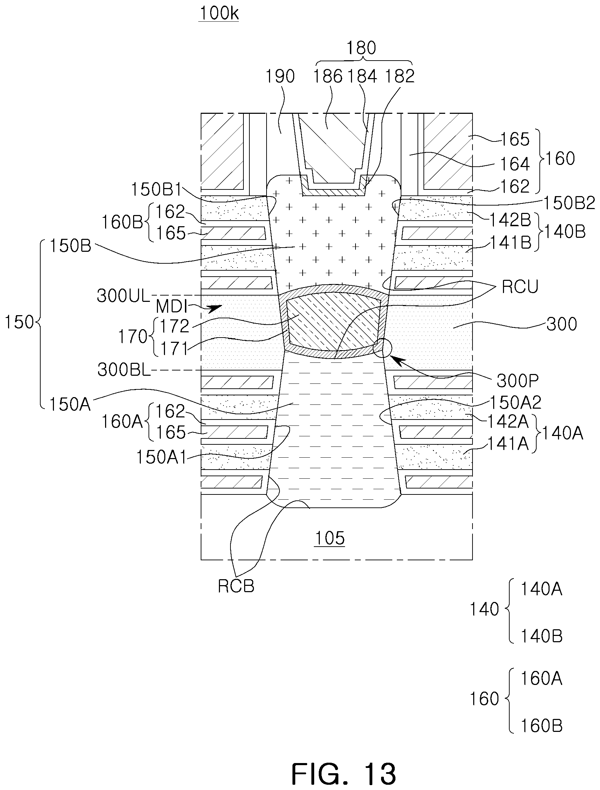

FIG. 13 is an enlarged cross-sectional diagram illustrating a portion of a semiconductor device according to example implementations, illustrating a region corresponding to FIG. 2B.

Referring to FIG. 13, the shape of the barrier structure 170 of the semiconductor device 100k may be different from that of the semiconductor device 100h in FIG. 10. The upper surface of the barrier structure 170 may be convex upwardly toward the upper source/drain region 150B, and the lower surface of the barrier structure 170 may be convex downwardly toward the lower source/drain region 150A. However, the shape is not limited to the above-described shape. In another example implementation, the upper surface of the barrier structure 170, that is, the upper surface of the first barrier pattern 171, may have a wavy shape, and the lower surface of the barrier structure 170, that is, the lower surface of the first barrier pattern 171, may also have a wavy shape, which may be due to the shape of the upper surface of the lower source/drain region 150A and the lower surface of the upper source/drain region 150B.

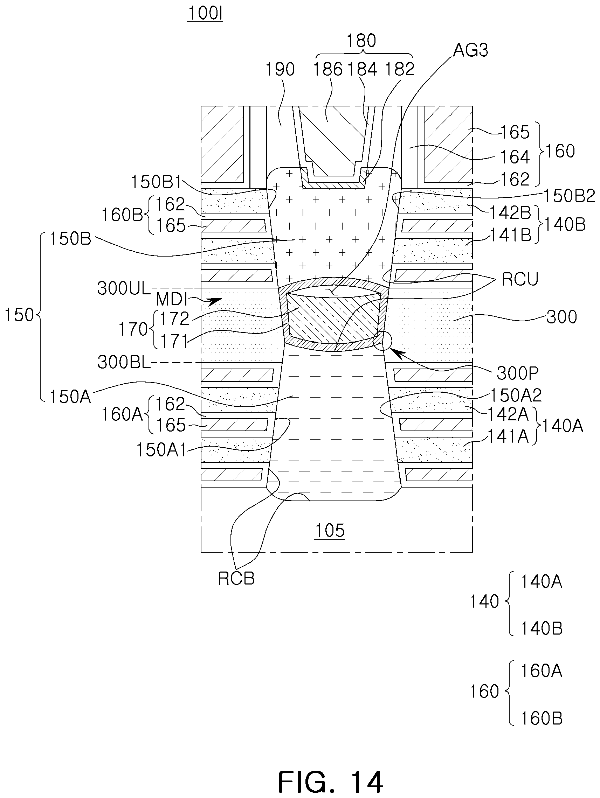

FIG. 14 is an enlarged cross-sectional diagram illustrating a portion of a semiconductor device according to example implementations, illustrating a region corresponding to FIG. 2B.

Referring to FIG. 14, the semiconductor device 100L may further include a third air gap AG3 between the upper surface of the second barrier pattern 172 and the lower surface of the upper source/drain region 150B. The shape of the first barrier pattern 171 may be identically applied to the description of the shape of the first barrier pattern 171 in FIG. 13. In the example implementation in FIG. 14, the description of the third air gap AG3 may be substantially the same as the description of the third air gap AG3 in FIG. 11.

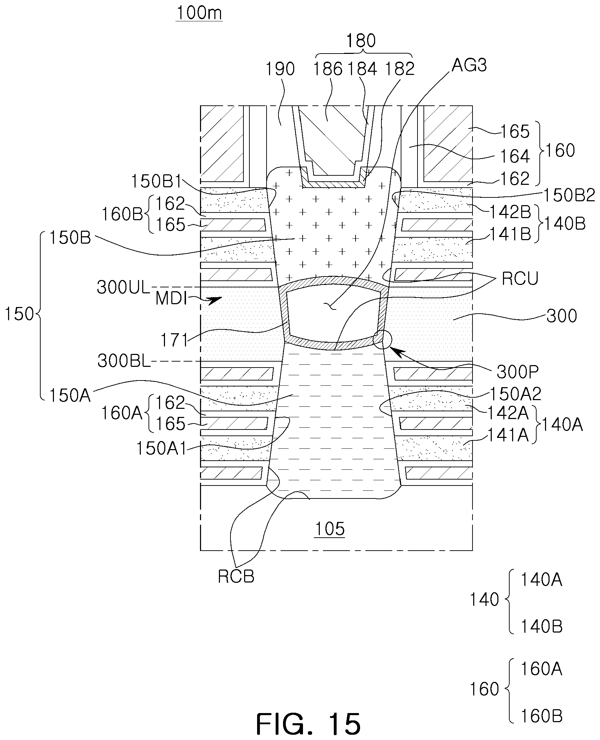

FIG. 15 is an enlarged cross-sectional diagram illustrating a portion of a semiconductor device according to example implementations, illustrating a region corresponding to FIG. 2B.

Referring to FIG. 15, the semiconductor device 100m may not include the second barrier pattern 172, but may include a third air gap AG3 surrounded by the first barrier pattern 171. The shape of the first barrier pattern 171 may be identically applied to the description of the shape of the first barrier pattern 171 in FIG. 13. In the example implementation in FIG. 15, the description of the third air gap AG3 may be substantially the same as the description of the third air gap AG3 in FIG. 12.

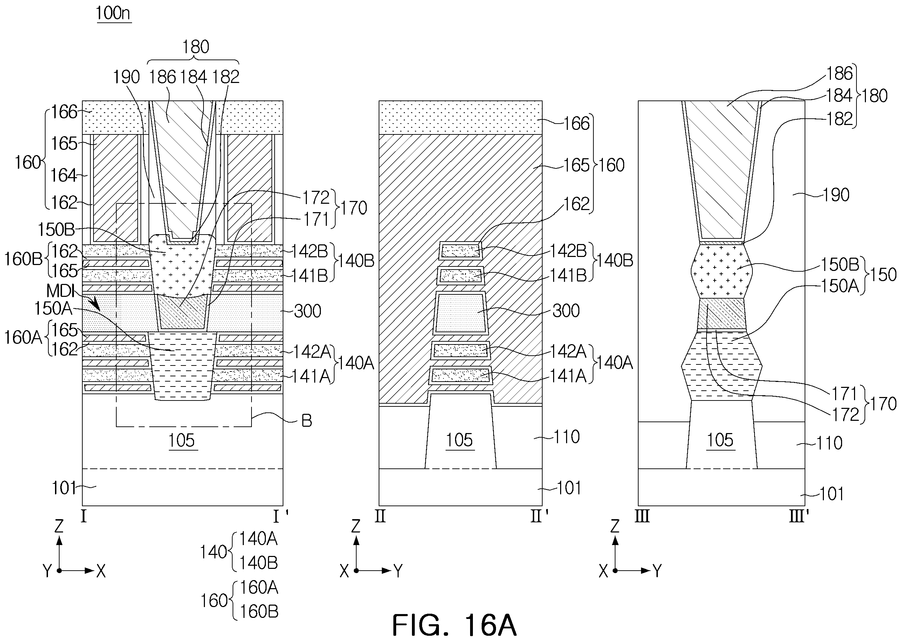

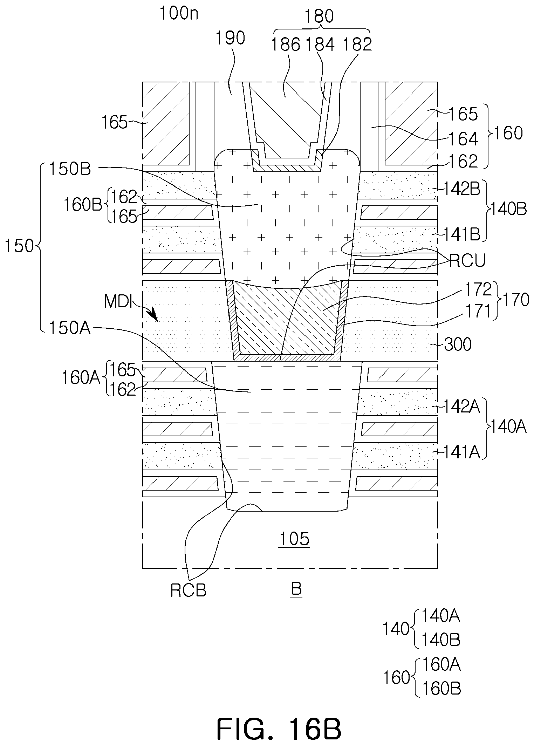

FIG. 16A is cross-sectional diagrams illustrating a semiconductor device. FIG. 16B is an enlarged cross-sectional diagram illustrating a portion of a semiconductor device. FIG. 16A illustrates a region corresponding to FIG. 2A, and FIG. 16B illustrates an enlarged 'B' region in FIG. 16A.

Referring to FIGS. 16A and 16B, a cross-sectional surface in the X-direction of the lower source/drain region 150A in the semiconductor device 100n may have an inverted trapezoid shape (i.e., the narrower base of the trapezoid is closer to the substrate than the wider base of the trapezoid). In example implementations, a width of the upper portion of the width in the X-direction of the lower source/drain region 150A may be greater than a width of the lower portion. In the process of forming the lower source/drain region 150A, a recess region may be further formed in the horizontal direction (e.g., the X-direction and the Y-direction), such that the width in the X-direction of the upper portion of the lower source/drain region 150A may be greater than the lower width in the X-direction of the barrier structure 170. Since a recess region is further formed in the horizontal direction, the cross-sectional surface of the lower source/drain region 150A in the Y-direction on the active region 105 may have a hexagonal or pentagonal shape. A bent portion in the portion in which the upper surface of the lower source/drain region 150A and the side surface of the barrier structure 170 may be connected to each other may be obtained.

In example implementations, a width of the lower gate structure 160A in the X-direction may gradually increase toward an upper surface of the substrate 101. A width in the X-direction of lower channel layers 141A and 142A may gradually increase toward the upper surface of the substrate 101. Among the lower channel layers 141A and 142A, the width of the second lower channel layer 142Ain the X-direction, which is the uppermost channel layer, may be substantially the same as or smaller than the width of the first upper channel layer 141B in the X-direction, which is the lowermost channel layer among upper channel layers 141B and 142B. In the process of forming the lower source/drain region 150A, by forming an additional recess region in the horizontal direction, a length of the lower channel layers 141A and 142A may be adjusted and the process of forming the epitaxial layer may be improved.

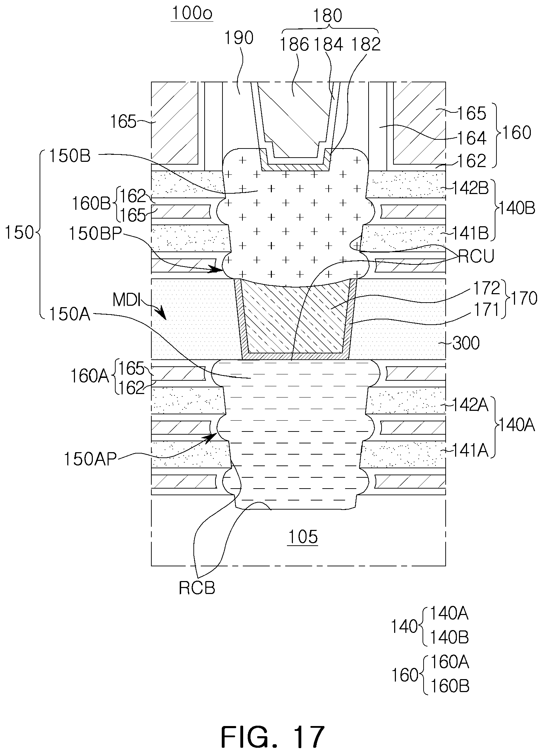

FIG. 17 is an enlarged cross-sectional diagram illustrating a portion of a semiconductor device according to example implementations, illustrating a region corresponding to FIG. 16B.

Referring to FIG. 17, in a semiconductor device 100n in FIG. 16B, when a recess region is further formed in the horizontal direction (e.g., the X-direction and the Y-direction) to form the lower source/drain region 150A, the lower source/drain region 150A may include the lower source/drain protrusion region 150AP. In example implementations, in the process in FIG. 19C described later, the lower source/drain protrusion region 150AP may be formed by forming the lower recess region RCB, further forming the lower recess region RCB in the horizontal direction through a wet etching process, and forming the lower source/drain region 150A in lower recess region RCB. The upper source/drain protrusion region 150BP may be formed by forming the upper recess region RCU, further forming the upper recess region RCU in the horizontal direction through a wet etching process, and forming the upper source/drain region 150B in the upper recess region RCU. In FIG. 17, the upper source/drain protrusion region 150BP may also be formed, but only the lower source/drain protrusion region 150AP may be formed, or only the upper source/drain protrusion region 150BP may be formed. The forming the lower source/drain protrusion region 150AP and the forming the upper source/drain protrusion region 150BP may be independent of each other.

FIG. 18 presents cross-sectional diagrams illustrating a portion of a semiconductor device, illustrating a region corresponding to FIG. 2A.

Referring to FIG. 18, in addition to the components of the semiconductor device 100 in FIG. 2A, a semiconductor device 100p in FIG. 18 may include a wiring structure including a via VA and a metal interconnection ML, a lower insulating structure (a bottom dielectric isolation structure; BDI), a backside contact structure 210, a backside power structure 195, and a lower insulating layer 196.

The via VA may penetrate through the first upper portion insulating layer 192. The via VA may be connected to the contact structure 180. The via VA may be formed of a conductive material.

The metal interconnection ML may form a back end of line BEOL together with the via VA. The metal interconnection ML and the via VA may be provided as an interconnection portion for signal transmission. In example implementations, a signal network may be configured by being connected to the device region (e.g., the source/drain region 150 and the gate electrode 165) through the contact structure 180 from the metal interconnection ML and the via VA. The via VA and the metal interconnection ML may also be applied to the semiconductor device 100, but may not be provided for ease of description.

The lower insulating structure BDI may be disposed between the lowermost surface of the lower gate structure 160A and the upper surface of the active region 105. The lower insulating structure BDI may include substantially the same material as that of the intermediate insulating structure MDI, but an example implementation thereof is not limited thereto.

The backside contact structure 210 may be connected to the lower source/drain region 150A by penetrating the substrate 101 below the lower source/drain region 150A. The backside contact structure 210 may penetrate through the substrate 101 and may extend vertically. The side surface of the backside contact structure 210 and the side surface of the substrate 101 may be in contact with each other. The backside contact structure 210 may be a self-aligned contact (SAC) aligned by the lower insulating structure BDI. Accordingly, a contact margin may be assured between the backside contact structure 210 and the lower source/drain region 150A. The backside contact structure 210 may be partially recessed into the lower region of the lower source/drain region 150A and may be in contact with the recessed lower surface of the lower source/drain region 150A.

The backside contact structure 210 may include a liner layer 214, a second metal-semiconductor compound layer 212, and a conductive layer 216. Although not illustrated, the backside contact structure 210 may further include an insulating liner for insulation from the substrate 101. The liner layer 214 may form an external side surface of the backside contact structure 210 and a portion of the upper surface of the backside contact structure 210. However, the extension range of liner layer 214 may vary in example implementations. The liner layer 214 may include a metal nitride, such as titanium nitride (TiN), tantalum nitride (TaN), or tungsten nitride (WN), for example.

The second metal-semiconductor compound layer 212 may be disposed on an upper end of the backside contact structure 210 and may form at least a portion of the upper surface of the backside contact structure 210. The second metal-semiconductor compound layer 212 may be disposed on the surface on which the backside contact structure 210 may be in contact with the source/drain region 150. However, in example implementations, the scope of the second metal-semiconductor compound layer 212 may not be limited to the illustrated example. The second metal-semiconductor compound layer 212 may be, for example, a metal silicide layer. The conductive layer 216 may be disposed to fill a contact hole surrounded by the liner layer 214 and the second metal-semiconductor compound layer 212. The conductive layer 216 may include a metal material such as aluminum (Al), tungsten (W), or molybdenum (Mo). In example implementations, the number of the conductive layers included in the backside contact structure 210 and the arrangement form thereof may be changed in various manners. In some example implementations, the liner layer 214 and/or the second metal-semiconductor compound layer 212 may not be provided.

The backside power structure 195 may be connected to a lower end or a lower surface of the backside contact structure 210. The backside power structure 195, together with the backside contact structure 210, may form a backside power delivery network (BSPDN) applying power or ground voltage, and may also be referred to as a backside power rail or a buried power rail. For example, the backside power structure 195 may be a buried interconnection line extending in a direction, for example, the Y-direction, below the backside contact structure 210, but the form of the backside power structure 195 is not limited thereto. For example, in some example implementations, the backside power structure 195 may include a via region and/or a line region. The backside power structure 195 may include a conductive material, for example, at least one of tungsten (W), copper (Cu), aluminum (Al), cobalt (Co), ruthenium (Ru), titanium (Ti), and molybdenum (Mo).

The lower insulating layer 196 may be disposed to cover the substrate 101. The lower insulating layer 196 may include at least one of an oxide, nitride, and oxynitride, and may include, for example, a low dielectric constant material. In example implementations, the lower insulating layer 196 may include a plurality of insulating layers.

FIGS. 19A to 19H are cross-sectional diagrams illustrating a method of manufacturing a semiconductor device, illustrating an example embodiment of a method of manufacturing the semiconductor device 100 in FIGS. 1 to 2B and cross-sectional surfaces corresponding to FIG. 2A.

Referring to FIG. 19A, sacrificial layers 120, lower channel layers 141A and 142A, semiconductor pattern 140S, and upper channel layers 141B and 142B may be stacked alternately on the substrate 101, an active structure may be formed, and sacrificial gate structures 200 may be formed in the second direction Y to intersect the active structure.

The sacrificial layers 120 may include lower sacrificial layers 120A, intermediate sacrificial layers 120B, and upper portion sacrificial layers 120C. The lower sacrificial layers 120A and the upper portion sacrificial layers 120C may be replaced with the gate dielectric layer 162 and the gate electrode 165 through a subsequent process as illustrated in FIG. 2A. The intermediate sacrificial layers 120B and the semiconductor pattern 140S may be replaced with the intermediate insulating structure MDI through a subsequent process as illustrated in FIG. 2A.

The sacrificial layers 120 may be formed of a material having etch selectivity with respect to the lower channel layers 141A and 142A, the semiconductor pattern 140S, and the upper channel layers 141B and 142B. The lower channel layers 141A and 142A, the semiconductor pattern 140S, and the upper channel layers 141B and 142B may include materials different from that of the sacrificial layers 120. In example implementations, the lower channel layers 141A and 142A, the semiconductor pattern 140S, and the upper channel layers 141B and 142B may include silicon (Si), and the sacrificial layers 120 may include silicon germanium (SiGe), but an example implementation thereof is not limited thereto.

The sacrificial layers 120, the lower channel layers 141A and 142A and the upper channel layers 141B and 142B may be formed by performing an epitaxial growth process using the substrate 101 as a seed. Each of the sacrificial layers 120, the lower channel layers 141A and 142A, the semiconductor pattern 140S and the upper channel layers 141B and 142B may have a thickness ranging from about 1 Å to 100 nm (e.g. from 0.1 nm to 100 nm). The number of the lower channel layers 141A and 142A, the semiconductor pattern 140S and the upper channel layers 141B and 142B alternately stacked with the sacrificial layers 120 may be varied in example implementations.

Thereafter, active structures may be formed by removing a portion of the sacrificial layers 120, the lower channel layers 141A and 142A, the semiconductor pattern 140S, the upper channel layers 141B and 142B and the substrate 101, and sacrificial gate structures 200 may be formed on the active structures.

The active structure may include sacrificial layers 120, lower channel layers 141A and 142A, semiconductor pattern 140S, and upper channel layers 141B and 142B, which are alternately stacked with each other, and may further include an active region 105 formed by removing a portion of the substrate 101 and protruding to the upper surface of the substrate 101. The active structures may be formed in the form of lines extending in one direction, for example, the X-direction, and may be spaced apart from each other in the Y-direction.

A device isolation layer 110 may be formed in the region from which a portion of the substrate 101 is removed by filling an insulating material and recessed into the active region 105 to protrude. An upper surface of the device isolation layer 110 may be formed on a level lower than a level of the upper surface of active region 105.

The sacrificial gate structures 200 may be configured as a sacrificial structure formed through a subsequent process in the region in which the gate dielectric layer 162 and the gate electrode 165 are disposed in the upper portion of the channel structure 140, as illustrated in FIG. 2A. The sacrificial gate structures 200 may include first and second sacrificial gate layers 202, 205, and a mask pattern layer 206, which are stacked in order. The first and second sacrificial gate layers 202 and 205 may be patterned using the mask pattern layer 206. The first and second sacrificial gate layers 202 and 205 may be configured as an insulating layer and a conductive layer, respectively. For example, the first sacrificial gate layer 202 may include silicon oxide, and the second sacrificial gate layer 205 may include polysilicon. The mask pattern layer 206 may include silicon nitride. The sacrificial gate structures 200 may have a line shape intersecting the active structures and extending in one direction. For example, the sacrificial gate structures 200 may extend in the Y-direction and may be spaced apart from each other in the X-direction.

Referring to FIG. 19B, the intermediate insulating structure MDI may be formed, and the gate spacer layers 164 may be formed to cover an upper surface and a side surface of the sacrificial gate structure 200 and the active structures.

The intermediate sacrificial layers 120B and the semiconductor pattern 140S may have etch selectivity for the lower sacrificial layers 120A, the upper portion sacrificial layers 120C, the lower channel layers 141A and 142A, and the upper channel layers 141B and 142B, such that the intermediate sacrificial layers 120B and the semiconductor pattern 140S may be selectively removed. An intermediate insulating structure MDI may be formed by filling the intermediate insulating pattern 300 in the region from which the intermediate sacrificial layers 120B and the semiconductor pattern 140S have been removed. The intermediate insulating pattern 300 may include, for example, an oxide or nitride. In another example implementation, the semiconductor pattern 140S may not be removed. Also, in another example implementation, the semiconductor pattern 140S may have etch selectivity for the intermediate sacrificial layers 120B. The first air gap AG1 of the semiconductor device 100c in FIG. 5 may be formed by removing the intermediate sacrificial layers 120B, filling the region from which the intermediate sacrificial layers 120B has been removed with the intermediate insulating pattern 300, and removing the semiconductor pattern 140S.

Gate spacer layers 164 may be formed to cover both a sidewall and an upper surface of the sacrificial gate structures 200. The gate spacer layers 164 may form a film having a uniform thickness along the upper surface and the side surface of sacrificial gate structures 200 and the active structures. The gate spacer layers 164 may cover the upper surface of the device isolation layer 110. The gate spacer layers 164 may be formed of a material having a low dielectric constant and, for example, may include at least one of SiO, SiN, SiCN, SiOC, SiON, and SiOCN.

Referring to FIG. 19C, a portion of the gate spacer layers 164 may be removed, the upper channel layers 141B and 142B, the upper portion sacrificial layers 120C, and a portion of the intermediate insulating structure MDI may be removed, and the first barrier pattern 171 may be formed.

A portion of the gate spacer layers 164 may be removed by anisotropic etching. Accordingly, the upper surface of the device isolation layer 110, the upper surface of the sacrificial gate structures 200, and the gate spacer layers 164 present on the upper surface of the active structure may be removed. A portion of the gate spacer layers 164 present on the side surface of the active structure may also be removed such that the thickness may be reduced.

An upper recess region RCU may be formed by removing a portion of the exposed upper portion sacrificial layers 120C, the upper channel layers 141B and 142B, and the intermediate insulating structure MDI between the sacrificial gate structures 200.

Since the upper recess region RCU is formed in a direction in which a width in the first direction X decreases, the upper recess region RCU may have an inclined side surface. The upper recess region RCU may penetrate through at least a portion of the intermediate insulating structure MDI. A level of a lower end of the upper recess region RCU may be substantially the same as or lower than a level of the surface on which the intermediate insulating structure MDI and the upper portion sacrificial layer 120C are in contact with each other, and may be substantially equal to or higher than a level of the contact surface between the intermediate insulating structure MDI and the lower sacrificial layer 120A. In another example implementation, to manufacture the semiconductor device 100a in FIG. 3, the upper recess region RCU may be formed, and the upper recess region RCU may be further formed in the horizontal direction through a wet etching process.

The first barrier pattern 171 may be formed to cover the sacrificial gate structures 200, the gate spacer layers 164, and the active structure, upper recess region RCU. The first barrier pattern 171 may be formed as a film having a uniform thickness along an upper surface and a side surface of the sacrificial gate structures 200, an upper surface and a side surface of the gate spacer layers 164, an upper surface and a side surface of the active structure, a side surface and a lower surface of the upper recess region RCU, and an upper surface of the device isolation layer 110. The first barrier pattern 171 may be formed along the surface of the intermediate insulating structure MDI exposed by the upper recess region RCU. The first barrier pattern 171 may include an oxide or nitride.

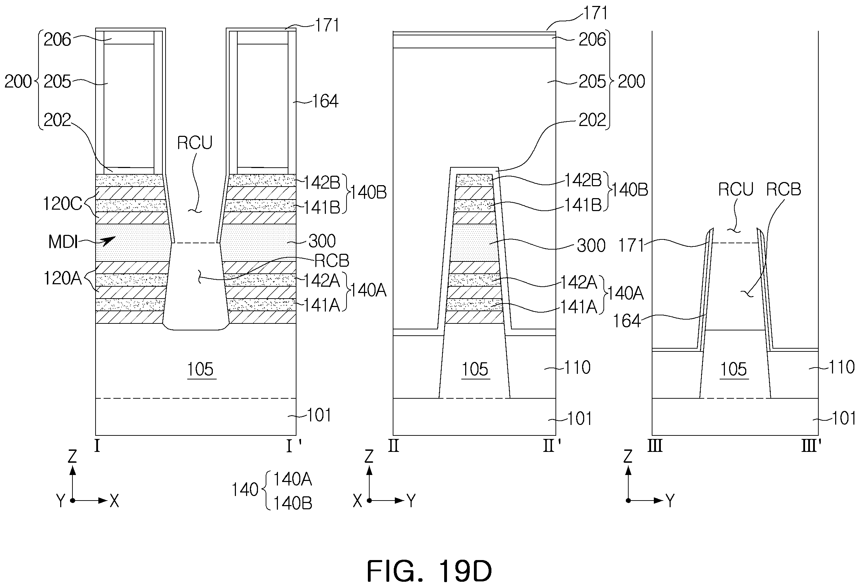

Referring to FIG. 19D, the lower recess region RCB may be formed by removing a portion of the first barrier pattern 171, the lower channel layers 141A and 142A, the lower sacrificial layers 120A, and a portion of the intermediate insulating structure MDI.

The first barrier pattern 171 exposed between the sacrificial gate structures 200 may be partially removed through an anisotropic etching process, and the lower channel layers 141A and 142A, the lower sacrificial layers 120A, and the intermediate insulating structure MDI may be removed, thereby forming a lower recess region RCB.

The lower recess region RCB may have a side surface such that a width thereof in the first direction X may gradually increase toward the upper surface of the substrate 101. The lower recess region RCB may partially remove the upper portion of the active region 105, but an example implementation thereof is not limited thereto. A width of the upper recess region RCU in the first direction X may gradually decrease toward the upper surface of the substrate 101. The width of the lower recess region RCB in the first direction X may decrease or increase toward the upper surface of substrate 101, such that an intermediate portion 300P, which is the portion in which the side surface of the lower recess region RCB meets the side surface of the upper recess region RCU may be included. In the intermediate portion 300P, a slope of the side surface of the lower recess region RCB may be converted to a positive slope or a negative slope, and a slope of the side surface of the upper recess region RCU may be converted to a negative slope or a positive slope. In another example implementation, to manufacture the semiconductor device 100a in FIG. 3, the lower recess region RCB may be formed, and the lower recess region RCB may be further formed in the horizontal direction through a wet etching process.

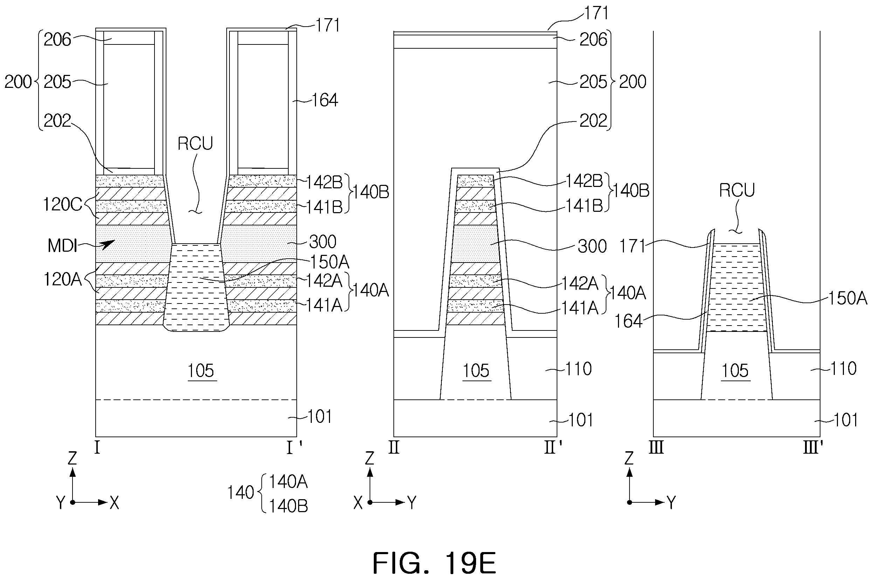

Referring to FIG. 19E, the lower source/drain region 150A may be formed by forming an epitaxial layer in the lower recess region RCB.

The lower source/drain region 150A may be formed by epitaxial growth and may extend to be in contact with the lower channel layers 141A and 142A and the lower sacrificial layers 120A in the lower recess region RCB. The lower surface of lower source/drain region 150A may have a downwardly convex shape, but an example implementation thereof is not limited thereto. The lower source/drain region 150A may include impurities due to in-situ doping. A level of an upper end of the lower source/drain region 150A (150AL, see FIG. 2B) may be higher than a level of the surface on which the intermediate insulating structure MDI and the lower sacrificial layer 120A are in contact with each other. An upper surface of the lower source/drain region 150A may be flat or convex upwardly depending on the types of impurities. Accordingly, the shape of the lower surface of the intermediate insulating structure MDI formed in the subsequent process may be varied.

Referring to FIG. 19F, a barrier structure 170 may be formed by forming the first barrier pattern 171 and the second barrier pattern 172.

The first barrier pattern 171 may be formed to cover an upper surface of the lower source/drain region 150A. The second barrier pattern 172 may be formed to fill a portion of the upper recess region RCU. The second barrier pattern 172 may have a shape in which the upper surface thereof may be convex downwardly. By removing the first barrier pattern 171 exposed on the sidewall and gate structure 160 of the upper recess region RCU and filling a portion of the upper recess region RCU with the second pattern 172, a barrier structure 170 may be formed. The second barrier pattern 172 may protect the first barrier pattern 171. In the process of removing first barrier pattern 171, the first barrier pattern 171 may also be removed from the device isolation layer 110.

Referring to FIG. 19G, the upper source/drain region 150B may be formed on the intermediate insulating structure MDI to fill the upper recess region RCU.

The upper source/drain region 150B may be formed by epitaxial growth and may extend to be in contact with the upper channel layers 141B and 142B and the upper portion sacrificial layers 120C in the upper recess region RCU. An upper surface of the upper source/drain region 150B may have an upwardly convex shape and a lower surface of the upper source/drain region 150B may have a downwardly convex shape, but an example implementation thereof is not limited thereto. The upper source/drain region 150B may include impurities due to in-situ doping.

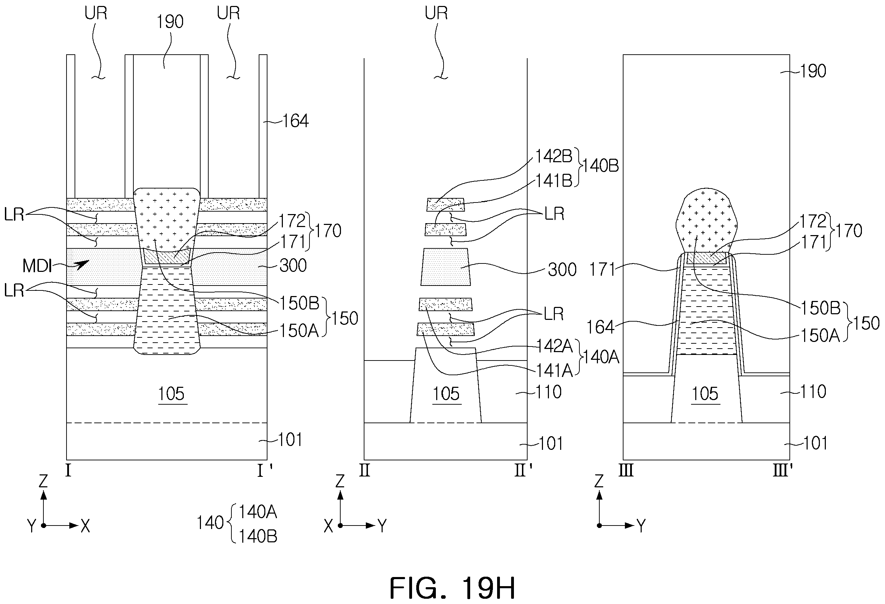

Referring to FIG. 19H, the interlayer insulating layer 190 may be formed, and the sacrificial gate structures 200, the upper portion sacrificial layers 120C, and the lower sacrificial layers 120A may be removed.

The interlayer insulating layer 190 may be formed by forming an insulating film covering the sacrificial gate structures 200 and the source/drain region 150 and performing a planarization process.

The sacrificial gate structures 200, the upper portion sacrificial layers 120C, and the lower sacrificial layers 120A may be selectively removed with respect to the gate spacer layers 164, the interlayer insulating layer 190, the lower channel layers 141A and 142A, the upper channel layers 141B and 142B, and the intermediate insulating structure MDI. First, the upper portion gap regions UR may be formed by removing the sacrificial gate structures 200, and the lower gap regions LR may be formed by removing the lower sacrificial layers 120A and the upper portion sacrificial layers 120C exposed through the upper portion gap regions UR. For example, when the lower sacrificial layers 120A and the upper portion sacrificial layers 120C include silicon germanium (SiGe), and the lower channel layers 141A and 142A and the upper channel layers 141B and 142B include silicon (Si), the lower sacrificial layers 120A and the upper portion sacrificial layers 120C may be selectively removed by performing a wet etching process using peracetic acid and/or a solution (NH₄OH:H₂O2:H₂O=1:1:5) used in the SC1 (Standard clean-1) cleaning process as an etchant.

Thereafter, referring to FIG. 2A, the gate dielectric layer 162 and the gate electrode 165 may be formed in the upper portion gap regions UR and the lower gap regions LR. The gate capping layer 166 may be formed in the upper portion gap regions UR. Also, the semiconductor device 100 illustrated in FIGS. 1 to 2B may be manufactured by forming the contact structure 180.

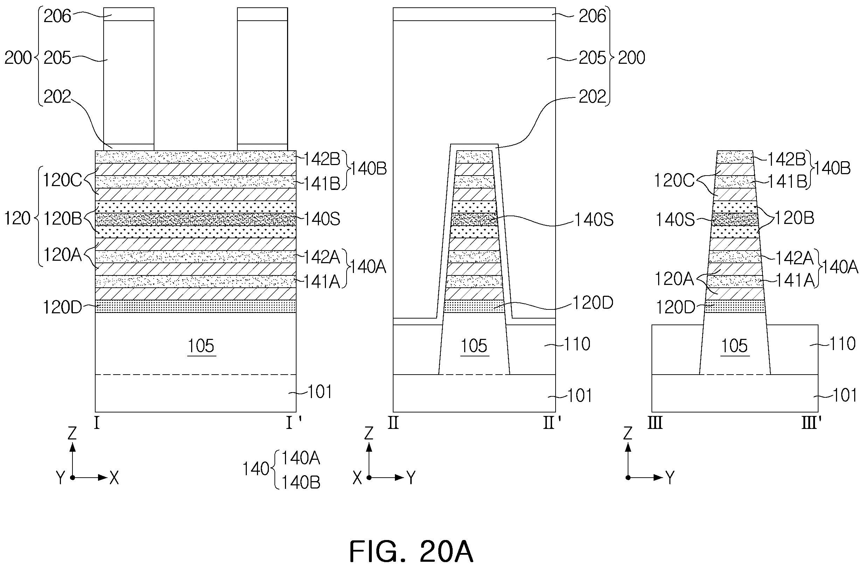

FIGS. 20A to 20J are cross-sectional diagrams illustrating a method of manufacturing a semiconductor device according to example implementations, illustrating an example implementation of the method of manufacturing the semiconductor device 100P in FIG. 18 and cross-sectional surfaces corresponding to FIG. 18.

Referring to FIG. 20A, a sacrificial barrier layer 120D may be formed on the substrate 101, and similarly to the process in FIG. 19A, the sacrificial layers 120, the lower channel layers 141A and 142A, the semiconductor pattern 140S, and the upper channel layers 141B and 142B may be alternately stacked, an active structure may be formed, and the sacrificial gate structures 200 may be formed in the second direction Y to intersect the active structure.

The sacrificial barrier layer 120D may be formed of a material having etch selectivity with respect to the sacrificial layers 120, the lower channel layers 141A and 142A, the semiconductor pattern 140S, and the upper channel layers 141B and 142B. The sacrificial barrier layer 120D may include silicon (Si) or silicon germanium (SiGe). When the sacrificial barrier layer 120D includes silicon germanium (SiGe), the sacrificial barrier layer 120D may have etch selectivity through a difference in germanium (Ge) concentration from the sacrificial layers 120. The sacrificial barrier layer 120D may be replaced with a lower insulating structure BDI through a subsequent process.

Thereafter, substantially the same process as in FIG. 19A may be performed.

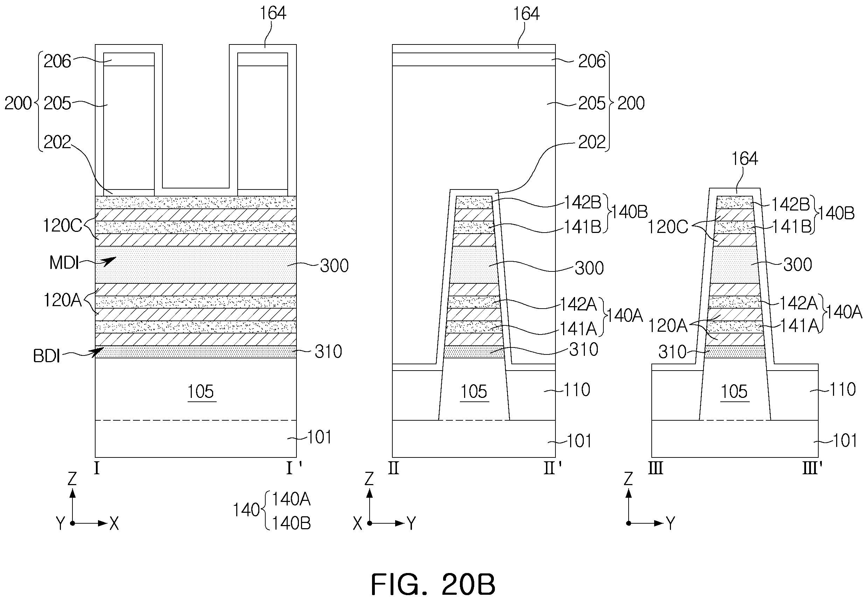

Referring to FIG. 20B, an intermediate insulating structure MDI and a lower insulating structure BDI may be formed, and gate spacer layers 164 may be formed.

An intermediate insulating structure MDI may be formed by selectively removing the intermediate sacrificial layers 120B and the semiconductor pattern 140S and filling the intermediate insulating pattern 300. A lower insulating structure BDI may be formed by selectively removing the sacrificial barrier layer 120D and filling the removed region with the lower insulating pattern 310. However, the process is not limited to the above-described process, the intermediate insulating structure MDI and the lower insulating structure BDI may be formed at the same time by simultaneously removing the sacrificial barrier layer 120D, the intermediate sacrificial layers 120B, and the semiconductor pattern 140S and filling the layers with an insulating material. According to another example implementation, the intermediate insulating structure MDI and the lower insulating structure BDI may be formed in the process of forming the gate structure 160. Thereafter, the gate spacer layers 164 may be formed by performing substantially the same process as in FIG. 19B.

Thereafter, substantially the same process as in FIGS. 19C and 19D may be performed.

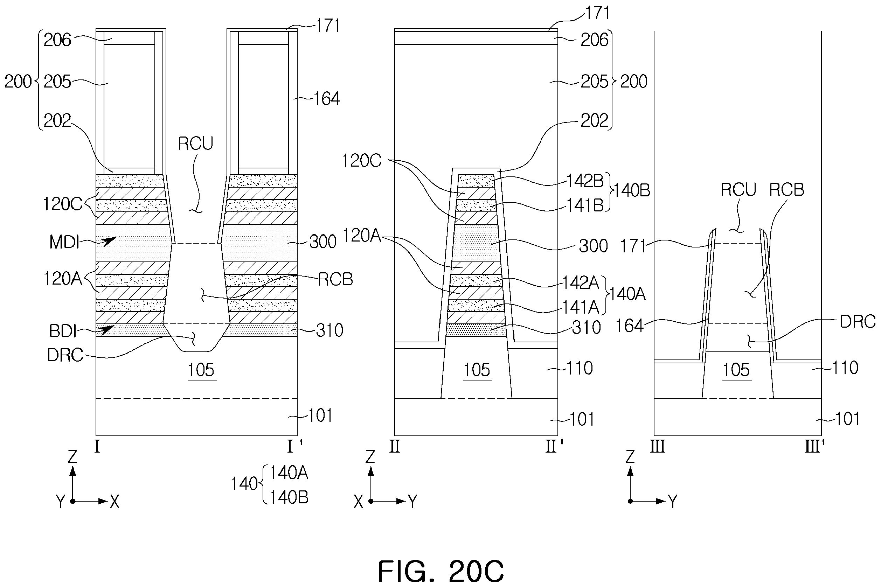

Referring to FIG. 20C, a dummy recess region DRC may be formed by partially removing the lower insulating structure BDI and the active region 105.

A dummy recess region DRC may be formed by partially removing the upper portion of the lower insulating structure BDI and the active region 105 through an etching process. The dummy recess region DRC may have a shape having a width decreasing toward the upper surface of the substrate 101, but an example implementation thereof is not limited thereto.

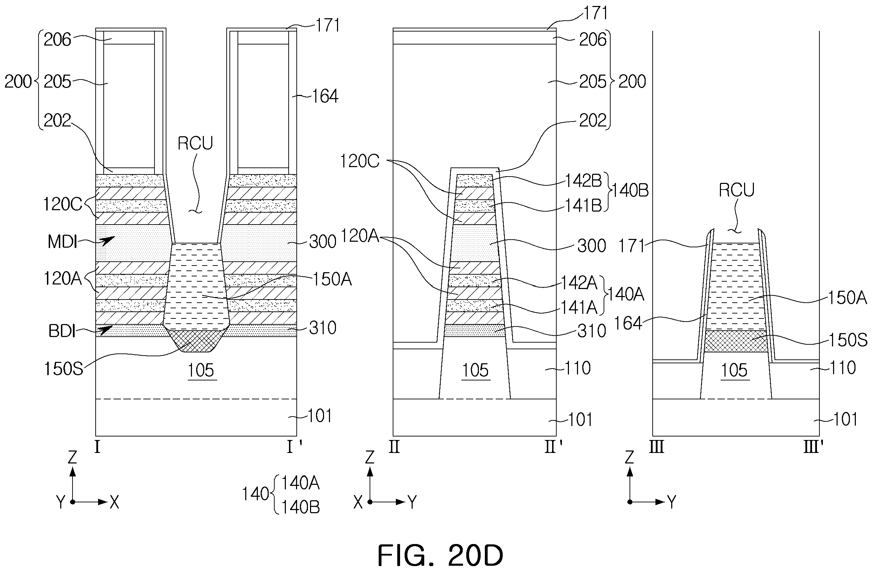

Referring to FIG. 20D, a sacrificial epitaxial layer 150S may be formed to fill the dummy recess region DRC, and a lower source/drain region 150A may be formed to fill the lower recess region RCB.

The sacrificial epitaxial layer 150S may be formed on the active region 105 between the gate spacer layers 164. The sacrificial epitaxial layer 150S may be formed by filling the dummy recess region DRC with a semiconductor material including at least one of silicon (Si), silicon germanium (SiGe), and germanium (Ge). In an example implementation, the sacrificial epitaxial layer 150S may include silicon germanium (SiGe).

Thereafter, the lower source/drain region 150A may be formed by performing substantially the same process as in FIG. 19E.

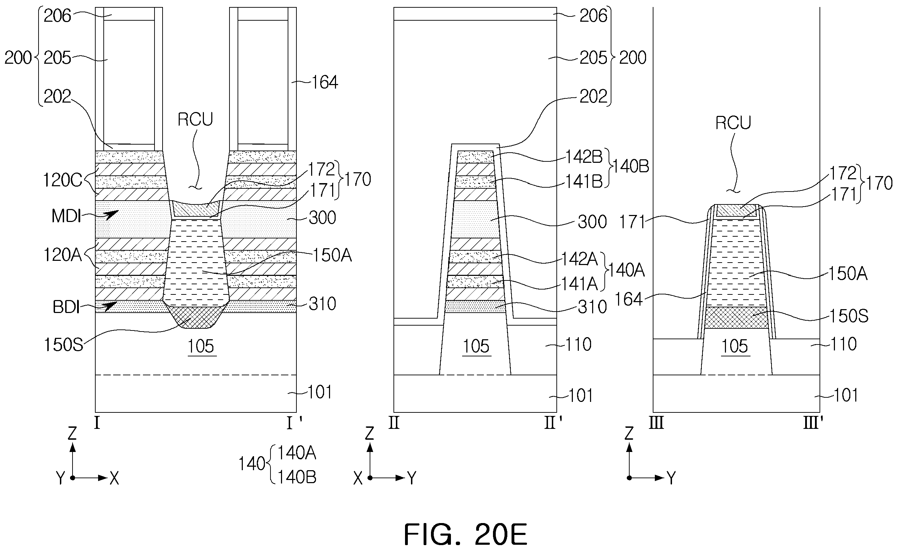

Referring to FIG. 20E, an intermediate insulating structure MDI may be formed by performing substantially the same process as in FIG. 19F.

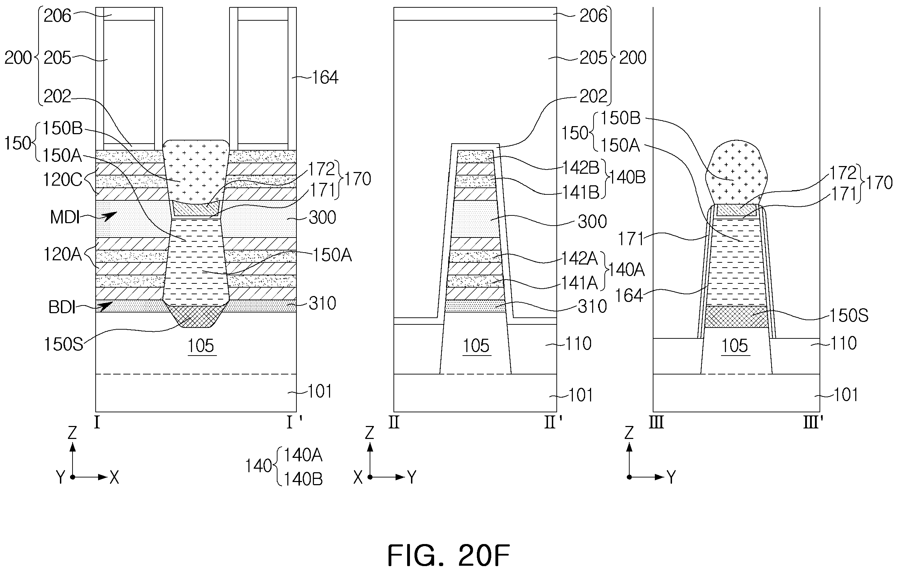

Referring to FIG. 20F, by performing substantially the same process as in FIG. 19G, the upper source/drain region 150B may be formed to fill the upper recess region RCU.

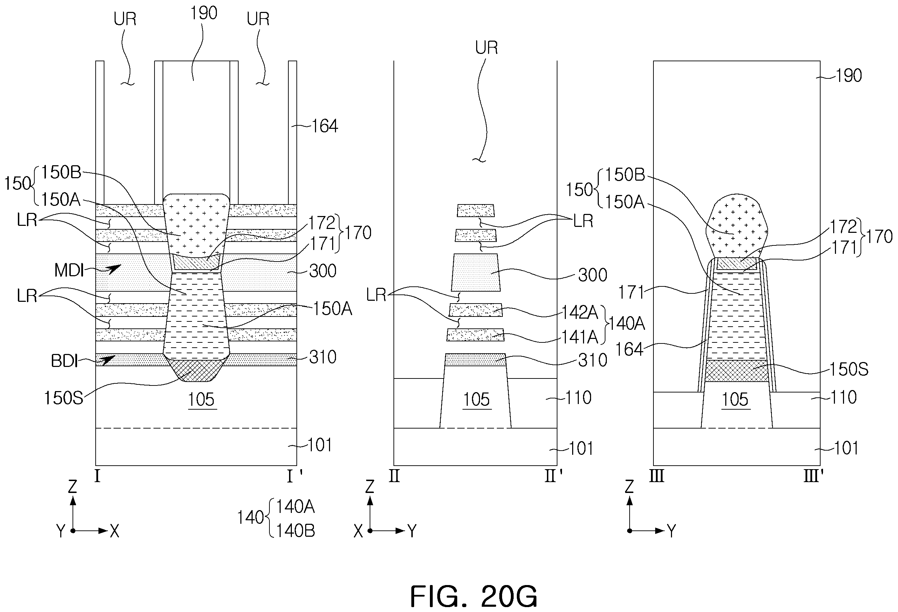

Referring to FIG. 20G, by performing substantially the same process as in FIG. 19H, the interlayer insulating layer 190 may be formed, and the sacrificial gate structures 200, the upper portion sacrificial layers 120C, and the lower sacrificial layers 120A may be removed. Accordingly, the upper portion gap regions UR and the lower gap regions LR may be formed.

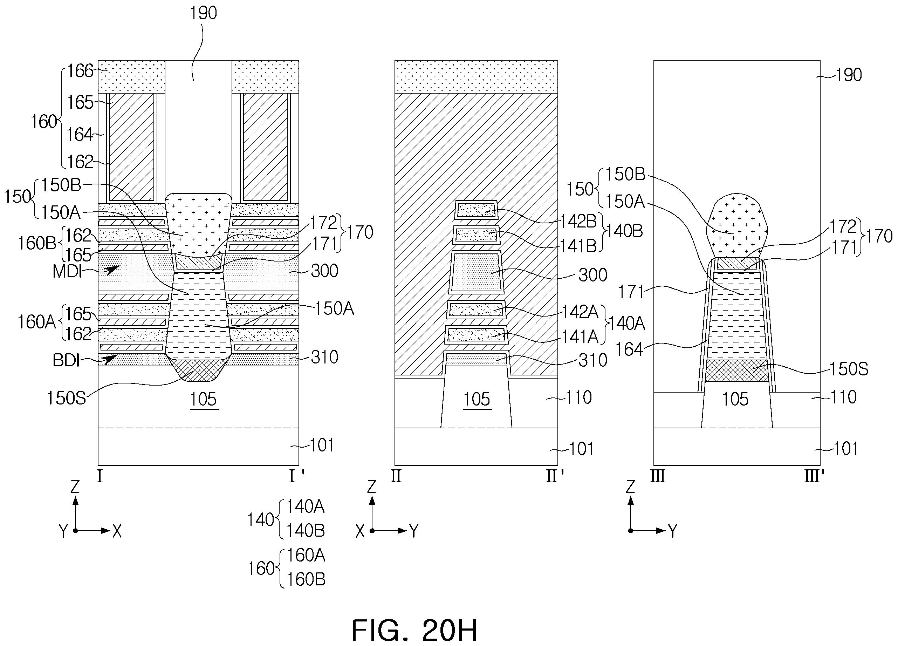

Referring to FIG. 20H, the gate structure 160 may be formed in the upper portion gap regions UR and the lower gap regions LR.

The gate dielectric layer 162 may be formed to conformally cover the inner surfaces of the upper portion gap regions UR and the lower gap regions LR. The gate electrode 165 may be formed to fill the upper portion gap regions UR and the lower gap regions LR. The gate electrode 165 and the gate spacer layers 164 may be removed to a predetermined depth from the upper portion in the upper portion gap regions UR. In the upper portion gap regions UR, gate capping layer 166 may be formed in the region from which the gate electrode 165 and the gate spacer layers 164 have been removed. Accordingly, a gate structure 160 including the gate dielectric layer 162, the gate electrode 165, the gate spacer layers 164, and the gate capping layer 166 may be formed.

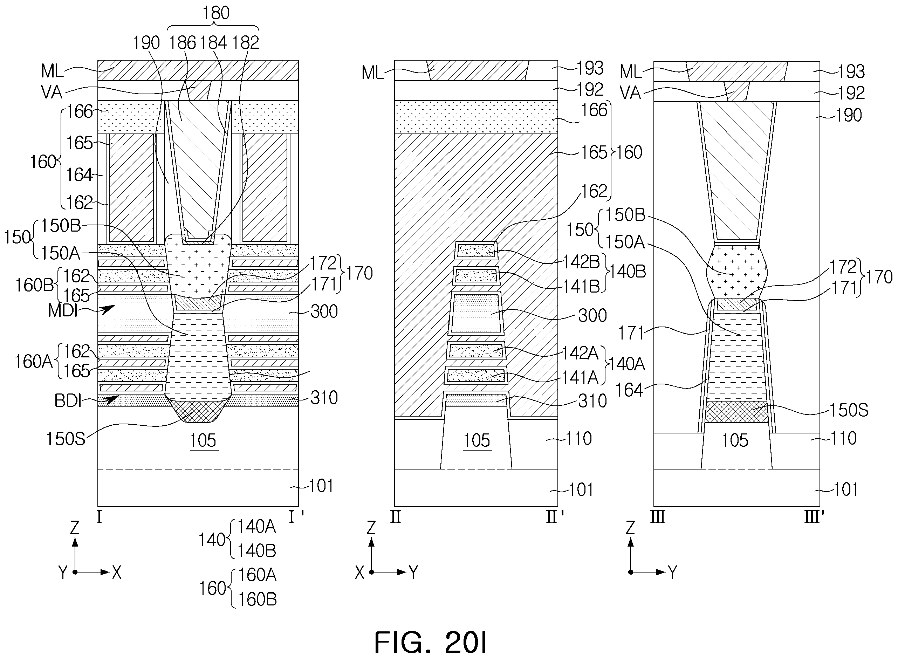

Referring to FIG. 20I, a contact structure 180, a via VA, and a metal interconnection ML may be formed.

A contact hole connected to the source/drain region 150 may be formed in the interlayer insulating layer 190, and a barrier layer 184 and a plug conductive layer 186 may be sequentially formed such that the contact hole is filled. Specifically, the material forming the barrier layer 184 may be filled in the contact holes, and by performing a silicide process, a first metal-semiconductor compound layer 182, such as a silicide layer, may be formed on a lower end. Thereafter, by performing a planarization process such as CMP, the upper surface of the contact structure 180 and the upper surface of the interlayer insulating layer 190 may be substantially coplanar with each other.

A first upper portion insulating layer 192 may be formed to cover the contact structure 180 and the gate structure 160, and a via VA penetrating through the first upper portion insulating layer 192 and connected to the contact structure 180 may be formed. A second upper portion insulating layer 193 may be formed to cover the first upper portion insulating layer 192 and the via VA, and the metal interconnection ML may be formed by patterning the second upper portion insulating layer 193 and filling the layer with a conductive material. The metal interconnection ML is not limited to the above-described process and may also be formed by a subtractive process.

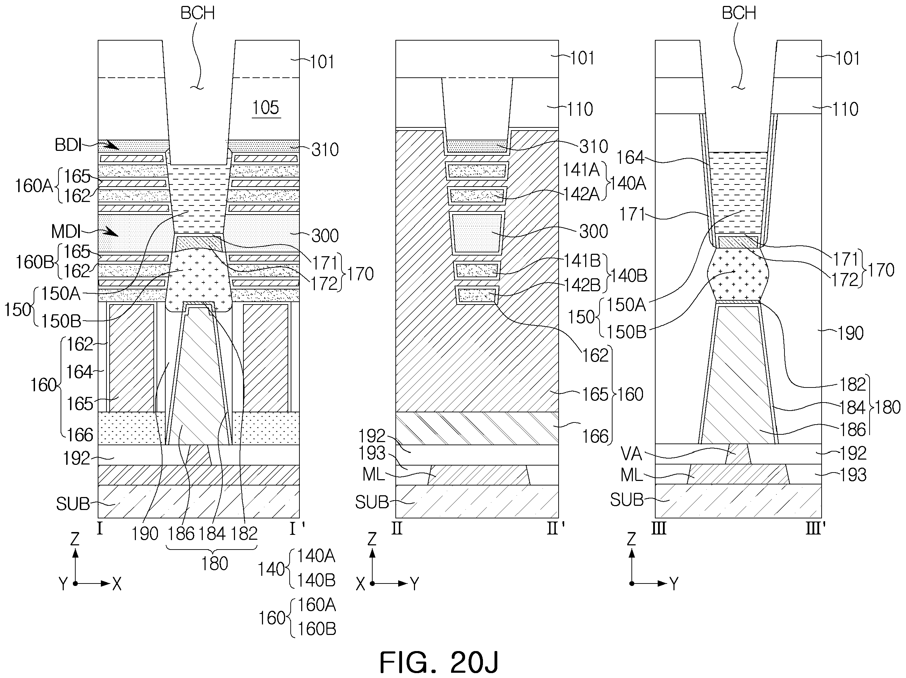

Referring to FIG. 20J, the entire structure formed with reference to FIGS. 20A to 20I may be attached to the carrier substrate SUB and a backside contact hole BCH may be formed.

The carrier substrate SUB may be attached to the second upper portion insulating layer 193 or the metal interconnection ML to perform a process on the lower surface of substrate 101 in FIG. 20I. In FIG. 20J, the entire structure may be rotated or inverted (e.g. may be flipped 180° about a horizontal axis) in a mirror image of the structure illustrated in FIG. 20I.

The substrate 101 may be penetrated such that the sacrificial epitaxial layer 150S may be exposed, and the sacrificial epitaxial layer 150S may be selectively removed. The sacrificial epitaxial layer 150S may be removed and a backside contact hole BCH may be formed to penetrate a portion of the lower source/drain region 150A, but an example implementation thereof is not limited thereto.

In another example implementation, the substrate 101 may be removed from the upper surface of the substrate 101, an insulating layer may be formed, and a backside contact hole BCH penetrating the insulating layer may be formed.

The backside contact structure 210 may be formed to fill the backside contact hole BCH. The second metal-semiconductor compound layer 212 may be formed by performing a metal-semiconductorization process, such as a silicidation process, using the lower source/drain region 150A exposed by the backside contact hole BCH. The backside contact structure 210 may be formed by forming a liner layer 214 on the side surface of the backside contact hole BCH and a conductive layer 216 to fill the backside contact hole BCH.

Thereafter, referring to FIG. 18, a backside power structure 195 may be formed.

After forming the lower insulating layer 196, the backside power structure 195 may be formed by partially removing the lower insulating layer 196, and the carrier substrate SUB may be removed. Accordingly, the semiconductor device 100h in FIG. 18 may be manufactured. The semiconductor device 100h may be packaged in a state in which the backside power structure 195 is disposed in the upper portion, but an example implementation thereof is not limited thereto.

According to the aforementioned example implementations, by including the structure including the first lower inclined surface, which is inclined such that the width of the lower source/drain region in the first direction decreases from the lower source/drain region toward the upper portion, and the second lower inclined surface having a different slope from that of the first lower inclined surface, the cross-sectional surface of the lower source/drain region in the X-direction may have a trapezoidal shape, such that a semiconductor device having improved electrical properties may be provided. As discussed herein a cross-section in a particular direction (e.g. a cross-sectional surface in the X-direction) may be a cross-section taken by viewing a structure along the particular direction (e.g. a cross-section taken by slicing along a plane perpendicular to the particular direction).

For instance, in a process of manufacturing a semiconductor device including a transistor (e.g. a transistor having a complementary field effect transistor (CFET) structure), lower source/drain regions may have a structure in which widths thereof may decrease toward an upper surface of a substrate. Accordingly, a width of the lower channel layers in the X-direction may increase toward the upper surface of the substrate, such that a deviation in the amounts of current flowing through the lower channel layers may occur, which may be problematic. To solve this problem, the present application proposes increasing the width of the lower source/drain regions toward the upper surface of the substrate. This causes the width of the lower channel layers in the X-direction to decrease toward the upper surface of the substrate, thereby reducing the deviation in the amounts of current through the lower channel layers.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

Embodiments are set out in the following clauses:
Clause 1. A semiconductor device, comprising:
   an active region extending on a substrate in a first direction;
   a device isolation layer disposed on the substrate and defining the active region;
   lower channel layers spaced apart from each other in a vertical direction perpendicular to an upper surface of the substrate;
   upper channel layers disposed on the lower channel layers and spaced apart from each other in the vertical direction;
   an intermediate insulating structure disposed between the uppermost lower channel layer among the lower channel layers and the lowermost upper channel layer among the upper channel layers;
   a lower gate structure intersecting the active region, surrounding each of the lower channel layers, extending in the second direction, and disposed below a lower surface of the intermediate insulating structure;
   an upper gate structure surrounding each of the upper channel layers, extending in the second direction, and disposed on an upper surface of the intermediate insulating structure;
   a lower source/drain region disposed on the active region on at least one side of the lower gate structure and connected to each of the lower channel layers;
   an upper source/drain region connected to each of the upper channel layers on at least one side of the upper gate structure and spaced apart from the lower source/drain region in the vertical direction; and
   a barrier structure disposed between the lower source/drain region and the upper source/drain region,
   wherein a width of an upper portion of the lower source/drain region in the first direction is greater than a width of a lower portion of the barrier structure in the first direction,
   wherein a width of the lower gate structure in the first direction increases or decreases toward an upper surface of the substrate, and
   wherein a width of the upper gate structure in the first direction increases toward an upper surface of the substrate.
Clause 2. The semiconductor device of clause 1,
   wherein a width of the lower channel layers in the first direction increases or decreases toward an upper surface of the substrate, and
   wherein a width of the upper channel layers increases in the first direction toward an upper surface of the substrate.
Clause 3. The semiconductor device of clause 1 or clause 2, wherein the intermediate insulating structure includes a plurality of intermediate insulating patterns and a semiconductor pattern between the plurality of intermediate insulating patterns.
Clause 4. The semiconductor device of any of clauses 1-3,
   wherein the intermediate insulating structure includes a first air gap, and
   wherein the first air gap vertically overlaps the lower gate structure and the upper gate structure.
Clause 5. The semiconductor device of clause 4,
   wherein the barrier structure includes a second air gap,
   wherein the second air gap vertically overlaps the lower source/drain region and the upper source/drain region, and
   wherein the first air gap and the second air gap are connected to each other.
Clause 6. The semiconductor device of any preceding clause,
   wherein the lower source/drain region is recessed into a portion of the active region and includes a lower source/drain protrusion region protruding toward the lower gate structure, and
   wherein the upper source/drain region includes an upper source/drain protrusion region protruding toward the upper gate structure.
Clause 7. The semiconductor device of any preceding clause,
   wherein a cross-sectional surface of the upper source/drain region in the first direction has an inverted trapezoidal shape, and
   wherein a cross-sectional surface of the lower source/drain region in the first direction has a trapezoidal shape or an inverted trapezoidal shape.
Clause 8. The semiconductor device of any preceding clause,
   wherein the barrier structure includes:
   a first barrier pattern formed along an upper surface of the lower source/drain region, a lower surface of the upper source/drain region, and a side surface of the intermediate insulating structure; and
   at least one of a second barrier pattern or a third air gap surrounded by the first barrier pattern.
Clause 9. A semiconductor device, comprising:
   an active region extending on a substrate in a first direction;
   a plurality of channel layers spaced apart from each other in a vertical direction perpendicular to an upper surface of the substrate;
   gate structures intersecting the active region, surrounding each of the plurality of channel layers and extending in a second direction;
   a lower source/drain region disposed on the active region on at least one side of the gate structures and connected to a portion of the plurality of channel layers;
   an upper source/drain region connected to the other portion of the plurality of channel layers on at least one side of the gate structures and spaced apart from the lower source/drain region in the vertical direction; and
   a barrier structure disposed between the lower source/drain region and the upper source/drain region,
   wherein the lower source/drain region includes a first lower inclined surface having a first slope and a second lower inclined surface having a second slope different from the first slope of the first lower inclined surface.
Clause 10. The semiconductor device of clause 9, wherein the upper source/drain region includes a first upper inclined surface inclined such that a width thereof in the first direction decreases downwardly from an upper portion of the upper source/drain region, and a second upper inclined surface inclined such that a width thereof in the first direction decreases downwardly from the upper portion of the upper source/drain region at a different rate from the first upper inclined surface.

While the example implementations have been illustrated and described above, it will be configured as apparent to those skilled in the art that modifications and variations could be made without departing from the scope of the present disclosure as defined by the appended claims.

## Claims

1. A semiconductor device, comprising:
an active region extending on a substrate in a first direction;
a device isolation layer disposed on the substrate and defining the active region;
lower channel layers spaced apart from each other in a vertical direction perpendicular to an upper surface of the substrate;
upper channel layers disposed on the lower channel layers and spaced apart from each other in the vertical direction;
an intermediate insulating structure disposed between an uppermost lower channel layer among the lower channel layers and a lowermost upper channel layer among the upper channel layers;
gate structures intersecting the active region, surrounding each of the lower channel layers and each of the upper channel layers and extending in a second direction;
a lower source/drain region disposed on the active region on at least one side of the gate structures and connected to the lower channel layers;
an upper source/drain region connected to each of the upper channel layers on at least one side of the gate structures and spaced apart from the lower source/drain region in the vertical direction; and
a barrier structure disposed between the lower source/drain region and the upper source/drain region,
wherein the lower source/drain region fills a lower recess region defined by a side surface of the lower channel layers, a side surface of the gate structures, and an upper surface of the active region,
wherein the upper source/drain region fills an upper recess region defined by a side surface of the upper channel layers, a side surface of the gate structures, and a lower surface and a side surface of the barrier structure, and
wherein a slope of a side surface of the lower recess region and a slope of a side surface of the upper recess region have slopes of opposite signs.

2. The semiconductor device of claim 1, further comprising:
an intermediate portion, which is a portion in which a side surface of the lower recess region meets a side surface of the upper recess region,
wherein, in the intermediate portion is a concave portion formed by an upper part of the lower recess region and a lower part of the upper recess region.

3. The semiconductor device of claim 2, wherein a level of the intermediate portion is substantially equal to or lower than a level of the upper surface of the intermediate insulating structure and is substantially equal to or higher than a level of a lower surface of the intermediate insulating structure.

4. The semiconductor device of claim 2 or claim 3, wherein a side surface of the lower source/drain region and a side surface of the upper source/drain region extend and meet each other in the intermediate portion.

5. The semiconductor device of any of claims 2-4, wherein a level of the intermediate portion is substantially equal to or higher than a level of the uppermost surface of the gate structure disposed below a lower surface of the intermediate insulating structure and is substantially equal to or lower than a level of the lowermost surface of the gate structure disposed on an upper surface of the intermediate insulating structure.

6. The semiconductor device of any preceding claim, further comprising:
internal spacer layers in contact with at least one of the lower source/drain region and the upper source/drain region and disposed on both sides of the gate structure in the first direction.

7. The semiconductor device of any preceding claim,
wherein, a thickness of the uppermost channel layer among the upper channel layers is greater than a thickness of each of the lower channel layers and also greater than a thickness of each of the upper channel layers other than the uppermost channel layer, and
wherein the lower recess region is symmetrical with the upper recess region with respect to a surface on which the barrier structure and the lower source/drain region meet each other.

8. The semiconductor device of any preceding claim, further comprising:
a lower insulating structure disposed between the lowermost surface of the gate structure and the upper surface of the active region, and
a backside contact structure penetrating through a portion of the lower source/drain region and the lower insulating structure and connected to the lower source/drain region below the lower source/drain region.

9. The semiconductor device of any preceding claim, wherein a level of a lowermost end of the upper source/drain region is lower than a level of an uppermost surface of the intermediate insulating structure.

10. The semiconductor device of any preceding claim, wherein the upper portion of the lower source/drain region horizontally overlaps the intermediate insulating structure.

11. The semiconductor device of any preceding claim,
wherein a width of the lower channel layers in the first direction decreases toward an upper surface of the substrate, and
wherein a width of the upper channel layers increases in the first direction toward an upper surface of the substrate.

12. The semiconductor device of any preceding claim, wherein the intermediate insulating structure includes a plurality of intermediate insulating patterns and a semiconductor pattern between the plurality of intermediate insulating patterns.

13. The semiconductor device of any preceding claim,
wherein the intermediate insulating structure includes a first air gap, and
wherein the first air gap vertically overlaps the gate structures.

14. The semiconductor device of claim 13,
wherein the barrier structure includes a second air gap,
wherein the second air gap vertically overlaps the lower source/drain region and the upper source/drain region, and
wherein the first air gap and the second air gap are connected to each other.

15. The semiconductor device of any preceding claim,
wherein the gate structures include a lower gate structure surrounding each of the lower channel layers and disposed below a lower surface of the intermediate insulating structure and an upper gate structure surrounding each of the upper channel layers and disposed on an upper surface of the intermediate insulating structure,
wherein the lower source/drain region is recessed into a portion of the active region and includes a lower source/drain protrusion region protruding toward the lower gate structure, and
wherein the upper source/drain region includes an upper source/drain protrusion region protruding toward the upper gate structure.
